(19) Europäisches Patentamt
European Patent Office
Office européen des brevets

(11) **EP 3 745 818 B1**

(12) **EUROPEAN PATENT SPECIFICATION**

(45) Date of publication and mention
of the grant of the patent:
**19.07.2023 Bulletin 2023/29**

(51) International Patent Classification (IPC):
**H05B 33/02** (2006.01)    **B82Y 20/00** (2011.01)
**H10K 50/85** (2023.01)    **H10K 50/854** (2023.01)

(21) Application number: **20185182.1**

(52) Cooperative Patent Classification (CPC):
**B82Y 20/00; H10K 50/85; H10K 50/854**

(22) Date of filing: **30.03.2012**

(54) **ORGANIC ELECTROLUMINESCENT ELEMENT**

ORGANISCHES ELEKTROLUMINESZENTES ELEMENT

ÉLÉMENT ÉLECTROLUMINESCENT ORGANIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.03.2011 JP 2011079477
09.11.2011 JP 2011245338
31.01.2012 JP 2012018648**

(43) Date of publication of application:
**02.12.2020 Bulletin 2020/49**

(62) Document number(s) of the earlier application(s) in
accordance with Art. 76 EPC:
**12764739.4 / 2 696 653**

(73) Proprietor: **SUMITOMO CHEMICAL COMPANY,
LIMITED
Tokyo 103-6020 (JP)**

(72) Inventor: **FUKUURA, Tomohiro
Tsukuba-shi, Ibaraki 300-3294 (JP)**

(74) Representative: **J A Kemp LLP
80 Turnmill Street
London EC1M 5QU (GB)**

(56) References cited:
EP-A1- 2 203 030          WO-A1-2008/082569
GB-A- 2 465 122          US-A1- 2007 114 523
US-A1- 2011 204 773

• **TOMOHIRO FUKUURA ET AL: "Long Range
Enhancement of Molecular Fluorescence by
Closely Packed Submicro-scale Ag Islands",
E-JOURNAL OF SURFACE SCIENCE AND
NANOTECHNOLOGY, vol. 7, 1 January 2009
(2009-01-01), pages 653-659, XP055132409, DOI:
10.1380/ejssnt.2009.653**

EP 3 745 818 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

# Description

## TITLE OF INVENTION

Organic Electroluminescence Device

## TECHNICAL FIELD

The present invention relates to an organic electroluminescence device (hereinafter also referred to as an organic EL device) exploiting plasmon resonance of a metal-based particle assembly in aiming for enhanced emission.

## BACKGROUND ART

It has conventionally been known that making metal particles small to be nano-sized presents functions that are not observed when it is in a bulk state, and localized plasmon resonance is in particular expected for application. Plasmon is a compressional wave of free electrons that arises by collective oscillation of the free electrons in a metallic nanostructure.

In recent years, a field of art handling the plasmon is referred to as plasmonics and attracts large attention, and has also been actively studied and such study includes exploiting phenomena of localized plasmon resonance of a metal nanoparticle to be intended for improvements of light emitting devices in luminescence efficiency.

Japanese Patent Laying-Open Nos. 2007-139540 (PTD 1) and 08-271431 (PTD 2) and WO2005/033335 (PTD 3), for example, disclose techniques exploiting localized plasmon resonance for enhanced fluorescence. Furthermore, T. Fukuura and M. Kawasaki, "Long Range Enhancement of Molecular Fluorescence by Closely Packed Submicro-scale Ag Islands", e-Journal of Surface Science and Nanotechnology, 2009, 7, 653 (NPD 1) indicates a study on localized plasmon resonance of silver nanoparticles.

EP 2203030 A1 discloses an organic electroluminescent device.

US 2007/114523 A1 discloses an electroluminescence element and display device.

WO 2008/082569 A1 discloses a nano structure optical wavelength filter.

US 2011/204773 A1 discloses an organic electroluminescence device.

GB 2465122 A discloses a vertical organic transistor.

## CITATION LIST

### PATENT DOCUMENTS

PTD 1: Japanese Patent Laying-Open No. 2007-139540
PTD 2: Japanese Patent Laying-Open No. 08-271431
PTD 3: WO2005/033335

### NON PATENT DOCUMENT

NPD 1: T. Fukuura and M. Kawasaki, "Long Range Enhancement of Molecular Fluorescence by Closely Packed Submicro-scale Ag Islands", e-Journal of Surface Science and Nanotechnology, 2009, 7, 653.

## SUMMARY OF INVENTION

### TECHNICAL PROBLEM

In recent years, studies and developments are actively done for applying organic EL devices to display devices or illumination devices, and are also put to practical use in part. However, current organic EL devices' luminous efficiency is held at a small value for the reasons indicated below and there is a demand for improving it.

(a) It is difficult to develop an organic luminescent material having high luminous efficiency and high durability and being suitable for mass production. While among organic luminescent materials a luminescent polymer that can form a film through a wet process is regarded as a hopeful material in terms of mass production and, inter alia, a phosphorescence emission polymer is regarded as a hopeful material in terms of luminous efficiency, it is not easy, even today, to design and implement a luminescent polymer having a significantly durable molecular structure and presenting sufficiently high luminous efficiency. In particular, it is extremely difficult to develop a blue luminescent organic material (or a luminescent organic material emitting lights in the range of neighboring wavelengths thereof) (a blue phosphorescence emission organic material, especially). This is because while a practically usable, tough molecular structure is required, a realization of emitting deep blue light, i.e., lights with a short wavelength of around 400 nm, requires, for example, sacrificing the molecule's stability and rendering a $\pi$ conjugated system in the molecular structure small to provide an increased bandgap.

(b) Light extraction efficiency is low. An organic EL device is formed of a stack of thin films including a light emitting layer and an electrode layer, so the light emitted from the light emitting layer will pass through a single layer or multiple layers when radiated outside the device. A light emitting layer and other layer(s) are generally different from each other in index of refraction, so the layers' interface causes reflection of light, and, especially, light totally reflected at the interface is internally confined, rather than radiated outside the device to dissipate as Joule heat. Thus, today light available for organic EL devices to (or light radiated outside the device) has an intensity of at most several tens percents of that of the light generated at the light emitting layer.

Aimed at solving such an issue of the organic EL devices and improving luminous efficiency thereof, it has been studied to apply to an organic EL device a plasmonic material represented by the aforementioned metal nanoparticle. Exploiting the metal nanoparticle's localized plasmon resonance to enhance emission, as conventional, is, however, accompanied by the following issue.

More specifically, a metal nanoparticle acts to enhance emission for the following two factors: 1) an electric field near the metal nanoparticle is enhanced through the generation of localized plasmon in the particle (a first factor); and 2) energy transfer from a molecule (a molecule of an organic luminescent material or the like) excited excites an oscillation mode of a free electron in the metal nanoparticle, which causes a radiative induced dipole in the metal nanoparticle larger than a radiative dipole of the excited molecule, and luminescent quantum efficiency per se thus increases (a second factor). In order to effectively cause, in the metal nanoparticle, the radiative induced dipole that is involved in the second factor, which is a larger factor, it is required that the metal nanoparticle and the molecule to be excited have a distance therebetween within a range disallowing energy transfer which is a direct electron transfer based on the Dexter mechanism to occur but allowing energy transfer based on the Forster mechanism to occur (i.e., a range of 1 nm to 10 nm). This is because the radiative induced dipole is caused based on the theory of Forster's energy transfer (see NPD 1 above).

In general, within the range of 1 nm to 10 nm, the metal nanoparticle and the molecule to be excited with a smaller distance therebetween facilitate causing the radiative induced dipole and allow an increased emission enhancement effect, whereas the metal nanoparticle and the molecule to be excited with a larger distance therebetween result in ineffective localized plasmon resonance and hence a gradually reduced emission enhancement effect, and the metal nanoparticle and the molecule to be excited with a distance therebetween exceeding the range allowing the Forster mechanism to present energy transfer (i.e., approximately 10 nm or larger in general) failed to provide a substantial emission enhancement effect. PTDs 1-3 also describe emission enhancement methods with a distance of 10 nm or smaller between a metal nanoparticle and a molecule to be excited to obtain an effective emission enhancement effect.

Localized plasmon resonance via a conventional metal nanoparticle thus has such an essential issue that it has an effect in an extremely limited range of 10 nm or smaller from a surface of the metal nanoparticle. This issue necessarily invites such an issue that attempts applying the localized plasmon resonance via the metal nanoparticle to an organic EL device, aimed at improving luminous efficiency, are not observed to provide substantial improvement effects. More specifically, an organic EL device normally has a light emitting layer having the thickness of several tens nm or larger, and even if the metal nanoparticle can be disposed adjacent to or in an active layer, a direct enhancement effect via localized plasmon resonance can only be obtained at an extremely small portion of the light emitting layer. It has thus been considered difficult to use a plasmonic material such as a metal nanoparticle to improve an organic EL device in luminous efficiency.

An object of the present invention is to provide an organic EL device including a novel plasmonic material contributing to enhanced emission and improvement of light extraction efficiency to present high luminous efficiency even when the device includes an inefficiently luminescent organic material.

SOLUTION TO PROBLEM

PTD 1 (see paragraphs 0010-0011) provides a theoretical explanation of a relationship between emission enhancement through localized plasmon resonance and a metal nanoparticle's particle diameter, and according to this explanation, when a spherical silver particle having a particle diameter of approximately 500 nm is used, while luminous efficiency $\varphi$ of approximately one is theoretically provided, in reality such a silver particle does not present a substantial effect to enhance emission. Such a large-size silver particle does not present a substantial effect to enhance emission because it is inferred that the silver particle has an excessively large number of surface free electrons therein, and accordingly, dipole-type localized plasmon observed in a typical nanoparticle (a nanoparticle having a relatively small particle diameter) is not easily generated. It is believed, however, that if a significantly large number of surface free electrons that the large-size nanoparticle has therein can be effectively excited as plasmon, it would be expected to contribute to drastically more effective enhancement via the plasmon.

As a result of a diligent study, the present inventor has found that when a large-size metal-based particle generally believed to provide a small emission enhancement effect, as set forth above, is formed to have a specific shape and at least a specific number of such particles are mutually separated in two dimensions and thus disposed to form a metal-based particle assembly, the assembly surprisingly can not only present significantly intense plasmon resonance but also allows the plasmon resonance to have an effect over a significantly extended range (or a plasmonic enhancement effect to cover the range) and that a layer (or film) that is formed of the metal-based particle assembly is introduced into an organic EL device, whereby luminous efficiency can be drastically improved.

The invention is defined in claim 1. Further aspects and preferred embodiments are defined in the dependent claims. Any aspects, embodiments and examples of the present disclosure which do not fall under the scope of the appended claims do not form part of the invention and are merely provided for illustrative purposes.

ADVANTAGEOUS EFFECT OF INVENTION

The present invention can thus provide an organic EL device including a metal-based particle assembly having a plasmonic property that a conventional plasmonic material does not have, and thereby achieving significantly intense enhanced emission and improvement of light extraction efficiency to exhibit high luminous efficiency even when using a luminescent organic material being low in luminous efficiency.

BRIEF DESCRIPTION OF DRAWINGS

Fig. 1 is a schematic cross section view of an example for an organic EL device of the present invention.
Fig. 2 is SEM images (as scaled 10000 times and 50000 times) of a metal-based particle assembly layer in a metal-based particle assembly layer-layered substrate obtained in Production Example 1, as observed from directly above.
Fig. 3 is an AFM image of the metal-based particle assembly layer in the metal-based particle assembly layer-layered substrate obtained in Production Example 1.
Fig. 4 is SEM images (as scaled 10000 times and 50000 times) of a metal-based particle assembly layer in a metal-based particle assembly layer-layered substrate obtained in Production Example 2, as observed from directly above.
Fig. 5 is an AFM image of the metal-based particle assembly layer in the metal-based particle assembly layer-layered substrate obtained in Production Example 2.
Fig. 6 represents absorption spectra of the metal-based particle assembly layer-layered substrates obtained in Production Example 1 and Comparative Production Examples 1 and 2.
Fig. 7 is an absorption spectrum of the metal-based particle assembly layer-layered substrate obtained in Production Example 2.
Fig. 8 is schematic flow diagrams showing a method for producing a reference metal-based particle assembly.
Fig. 9 is SEM images (as scaled 20000 times and 50000 times) of a reference metal-based particle assembly layer in a reference metal-based particle assembly layer-layered substrate as observed from directly above.

Fig. 10 illustrates an absorption spectrum measurement method using an objective lens (100 times) of a microscope.
Fig. 11 is an absorption spectrum of the metal-based particle assembly layer-layered substrate obtained in Production Example 1, as measured by a method using an objective lens (100 times) of a microscope.
Fig. 12 is an absorption spectrum of the metal-based particle assembly film-layered substrate obtained in Production Example 2, as measured by a method using an objective lens (100 times) of a microscope.
Fig. 13 is an SEM image (as scaled 10000 times) of a metal-based particle assembly layer in a metal-based particle assembly layer-layered substrate obtained in Comparative Reference Example 1-1, as observed from directly above.
Fig. 14 is an AFM image of the metal-based particle assembly layer in the metal-based particle assembly layer-layered substrate obtained in Comparative Reference Example 1-1.
Fig. 15 is absorption spectra of metal-based particle assembly layer-layered substrates obtained in a Reference Example 1-1 and Comparative Reference Example 1-1, as obtained by a measurement method using an integrating sphere spectrophotometer.
Fig. 16 is an absorption spectrum of the metal-based particle assembly layer-layered substrate obtained in Comparative Reference Example 1-1, as measured by a method using an objective lens (100 times) of a microscope.
Fig. 17 is SEM images (as scaled 10000 times and 50000 times) of a metal-based particle assembly film in a metal-based particle assembly film-layered substrate obtained in Comparative Reference Example 7-1, as observed from directly above.
Fig. 18 is an AFM image of the metal-based particle assembly film in the metal-based particle assembly film-layered substrate obtained in Comparative Reference Example 7-1.
Fig. 19 is an absorption spectrum of the metal-based particle assembly film-layered substrate obtained in Comparative Reference Example 7-1.
Fig. 20(a) schematically shows a system to measure an emission spectrum of a photoexcited light emitting device, and Fig. 20(b) is a schematic cross section view of a photoexcited light emitting device having a metal-based particle assembly layer and an insulating layer.
Fig. 21 compares emission enhancement effects in photoexcited light emitting devices of Reference Examples 1-1 to 1-6 with emission enhancement effects in photoexcited light emitting devices of Comparative Reference Examples 1-1 to 1-6.
Fig. 22 compares emission enhancement effects in photoexcited light emitting devices of Reference Examples 2-1 to 2-5 with emission enhancement effects in photoexcited light emitting devices of Comparative Reference Examples 3-1 to 3-5 and 7-1 to 7-5.

Fig. 23 compares emission enhancement effects in photoexcited light emitting devices of Reference Examples 3-1 to 3-3 with emission enhancement effects in photoexcited light emitting devices of Comparative Reference Examples 5-1 to 5-3.

DESCRIPTION OF EMBODIMENTS

The present invention provides an organic EL device in accordance with claim 1.

<Metal-Based Particle Assembly Layer>

The organic EL device of the present invention in a preferable embodiment includes a metal-based particle assembly layer having any of the following features:

[i] the metal-based particles that compose the metal-based particle assembly layer are disposed such that an average distance between adjacent metal-based particles may be in a range of from 1 to 150 nm (a first embodiment);

[ii] the metal-based particle assembly layer has in an absorption spectrum for a visible light region a maximum wavelength of a peak at a longest side in wavelength, and the maximum wavelength shifts toward a shorter side in wavelength in a range of from 30 to 500 nm as compared with that of a reference metal-based particle assembly (X) in which metal-based particles having a particle diameter equal to the average particle diameter and a height equal to the average height and made of the same material are disposed such that each distance between adjacent metal-based particles may be in a range of from 1 to 2 $\mu$m (a second embodiment); and

[iii] the metal-based particle assembly layer has in an absorption spectrum for a visible light region a maximum wavelength of a peak at a longest side in wavelength, and an absorbance at the maximum wavelength is higher as compared with that of a reference metal-based particle assembly (Y) in which metal-based particles having a particle diameter equal to the average particle diameter and a height equal to the average height and made of the same material are disposed such that each distance between adjacent metal-based particles may be in a range of from 1 to 2 $\mu$m, on the premise that the numbers of the metal-based particles are the same (a third embodiment).

In the present specification, a metal-based particle assembly having an average particle diameter and an average height equal to those of reference metal-based particle assembly (X) or (Y) means that the average particle diameters have a difference within a range of $\pm 5$ nm and the average heights have a difference within a range of $\pm 10$ nm.

First Embodiment

An organic EL device of the present embodiment including a metal-based particle assembly layer having the feature indicated above at item [i] is significantly advantageous as follows:

(1) The metal-based particle assembly layer according to the present embodiment exhibits significantly intense plasmon resonance and thus allows a stronger emission enhancement effect than a conventional plasmonic material, and hence drastically increased luminous efficiency. The metal-based particle assembly layer according to the present embodiment exhibits plasmon resonance having an intensity that is not a simple sum total of localized plasmon resonances that individual metal-based particles exhibit for a specific wavelength; rather, it exhibits an intensity larger than that. More specifically, 30 or more metal-based particles each having a prescribed shape are spaced as prescribed, as described above, to be closely disposed, thereby individually interacting with each other to exhibit significantly intense plasmon resonance. This is believed to be exhibited as the metal-based particles' localized plasmons interact with each other.

Generally, when a plasmonic material is subjected to absorption spectrum measurement through absorptiometry, a plasmon resonance peak (hereinafter also referred to as a plasmon peak) is observed as a peak in an ultraviolet to visible light region, and the plasmon peak's absorbance value in magnitude at a maximum wavelength thereof can be used to easily evaluate the plasmonic material's plasmon resonance in intensity, and when the metal-based particle assembly layer according to the present embodiment that is layered on a glass substrate is subjected to absorption spectrum measurement, it can present for a visible light region a maximum wavelength of a plasmon peak at a longest side in wavelength, and an absorbance at the maximum wavelength can be 1 or larger, further 1.5 or larger, and still further approximately 2.

The metal-based particle assembly layer's absorption spectrum is measured through absorptiometry with the layer layered on a glass substrate. More specifically, the absorption spectrum is obtained as follows: the glass substrate with the metal-based particle assembly layer layered thereon is exposed to light of the ultraviolet to visible light region incident on a back surface thereof (i.e., a side opposite to the metal-based particle assembly layer) in a direction perpendicular to a substrate surface and intensity I of transmitted light omnidirectionally transmitted toward the metal-based particle assembly layer is measured with an integrating sphere spectrophotometer. On the other hand, a substrate which does not have a metal-based particle assembly film and has the same thickness and the same material as the substrate of said metal-based particle assembly film-layered substrate is exposed at a surface thereof to the same incident light as above in a direction perpendicular to that surface and intensity $I_0$ of transmitted light omnidirectionally transmitted through a side opposite to the incident surface is measured with the integrating sphere spectrophotometer. Then, the absorption spectrum's axis of ordinate, or absorbance, is expressed by the following expression:

$$Absorbance = -\log_{10}(I/I_0).$$

(2) The metal-based particle assembly layer presents plasmon resonance having an effect over a significantly extended range (or a plasmonic enhancement effect covering the range) and thus allows a stronger emission enhancement effect than a conventional plasmonic material, and this, as well as the above, contributes to drastically improved luminous efficiency. The plasmon resonance having an effect over the significantly extended range allows a light emitting layer typically having the thickness of several tens nm or larger to be entirely enhanced, thereby significantly improving luminous efficiency of the organic EL device.

Such extension effects are also believed to be exhibited as 30 or more metal-based particles each having a prescribed shape, which are spaced, as prescribed to be closely disposed cause localized plasmons interacting with each other. Conventionally, plasmon resonance has an effect over a range that is generally limited to that of the Forster distance (i.e., approximately 10 nm or smaller), whereas the metal-based particle assembly layer according to the present embodiment allows the range to be extended for example to approximately several hundreds nm.

Furthermore, while a conventional plasmonic material needs to be disposed to have a distance to a light emitting layer within the range of the Forster distance, the organic EL device of the present embodiment can achieve effective enhancement via plasmon resonance with the metal-based particle assembly layer disposed at a position for example 10 nm, further several tens nm (e.g., 20 nm), still further several hundreds nm away from the light emitting layer. This means that the plasmonic material, or the metal-based particle assembly layer, can be disposed closer to a light extraction face than the light emitting layer, and, furthermore, in a vicinity of a light extraction face considerably remote from the light emitting layer, and significantly efficient extraction of light can thus be achieved. When a conventional plasmonic material is used to produce an organic EL device, the organic EL device necessitates having the plasmonic material disposed significantly close to the light emitting layer and hence significantly remote from the light extraction face, and accordingly, as has been set forth above, the light emitted from the light emitting layer would have a large portion thereof totally reflected at an interface of a device constituent layer that the light passes through before it reaches the light extraction face, resulting in significantly inefficient extraction of light.

While the metal-based particle assembly layer according to the present embodiment employs a metal-based particle of a relatively large size that would alone be less prone to generate dipole-type localized plasmon for a visible light region, the layer has at least a specific number of such particles, which are each required to have a prescribed shape, spaced as prescribed to be closely disposed so that a significantly large number of surface free electrons that the large-size metal-based particles include therein can be effectively excited as plasmon to achieve significantly intense plasmon resonance and plasmon resonance having an effect over a significantly extended range.

Furthermore, as the organic EL device of the present embodiment has a metal-based particle assembly layer configured such that at least a specific number of metal-based particles of a relatively large size having a specific shape are spaced in two dimensions, as prescribed, it can thereby have an advantageous effect, as follows.

(3) The metal-based particle assembly layer according to the present embodiment can present in an absorption spectrum for a visible light region a plasmon peak whose maximum wavelength presents a unique shift depending on its metal-based particles' average particle diameter and average interparticle distance, and thus allows light emission of a specific (or desired) wavelength range to be particularly enhanced. More specifically, when the metal-based particles have a fixed average interparticle distance while having increased average particle diameters, a plasmon peak at a longest side in wavelength for the visible light region has a maximum wavelength shifting toward a shorter side in wavelength (or blue-shifted). Similarly, when the large-size metal-based particles have a fixed average particle diameter while having decreased average interparticle distances (i.e., when the particles are disposed more closely), a plasmon peak at a longest side in wavelength for the visible light region has a maximum wavelength shifting toward a shorter side in wavelength. This unique phenomenon is contradictory to the Mie-scattering theory generally accepted regarding plasmonic materials (according to this theory, larger particle diameters result in a plasmon peak having a maximum wavelength shifting toward a longer side in wavelength (or red-shifted)).

It is believed that the unique blue shift as described above is also attributed to the fact that the metal-based particle assembly layer is structured with large-size metal-based particles spaced as prescribed to be closely disposed, followed by the metal-based particles having their localized plasmons interacting with each other. The metal-based particle assembly layer according to the present embodiment (when it is layered on a glass substrate) can present in an absorption spectrum for a visible light region, as measured through absorptiometry, a maximum wavelength of a plasmon peak at a longest side in wavelength, and the maximum wavelength can be in a wavelength range of for example from 350 to 550 nm, depending on the metal-based particles' shape and interparticle distance. Furthermore, the metal-based particle assembly layer according to the present embodiment can typically cause a blue shift of approximately 30-500 nm (e.g., 30-250 nm) as compared with that having metal-based particles with a sufficiently large interparticle distance (for example of 1 $\mu$m).

The organic EL device including a metal-based particle assembly layer with a plasmon peak having a maximum wavelength blue-shifted as described above is significantly advantageous for example as follows. More specifically, while there is a strong demand for a blue luminescent organic material (or a luminescent organic material of a wavelength range close thereto; the same applies hereinafter), in particular a blue phosphorescent material, presenting high luminous efficiency, currently it is difficult to develop such a material with sufficiently practical usability. Applying the metal-based particle assembly layer that has a plasmon peak, for example, in the blue wavelength range to an organic EL device as an enhancement element allows the organic EL device to have its luminous efficiency enhanced to a sufficient extent even when the organic device uses a blue luminescent organic material of relatively low luminous efficiency.

Hereinafter will be described a specific configuration of the metal-based particle assembly layer according to the present embodiment.

Metal-based particles that compose the metal-based particle assembly layer are not specifically restricted as long as made of a material having a plasmon peak in a ultraviolet to visible light region in absorption spectrum measurement through absorptiometry in the form of nanoparticles or an assembly of such particles, and the material can include, for example, noble metals such as gold, silver, copper, platinum and palladium; metals such as aluminum and tantalum; alloys containing these noble metals or these metals; and metal compounds including these noble metals or these metals (such as metal oxides, and metal salts). Inter alia, noble metals such as gold, silver, copper, platinum and palladium are preferable, and silver is more preferable as it is inexpensive and provides small absorption (or has a small imaginary part of a dielectric function in visible light wavelengths).

The metal-based particles have an average particle diameter within a range of 200-1600 nm, and to effectively obtain the effects of items (1) to (3) it falls within a range preferably of 200-1200 nm, more preferably 250-500 nm, still more preferably 300-500 nm. It should be noted here that a metal-based particle of a large size having an average particle diameter for example

ple of 500 nm is alone not observed to show substantially effective enhancement via localized plasmon. In contrast, the metal-based particle assembly layer according to the present embodiment has at least a prescribed number of (30) such large-size metal-based particles spaced as prescribed to be closely disposed, thereby achieving significantly intense plasmon resonance and plasmon resonance having an effect over a significantly extended range, and furthermore, the effect of item (3).

The average particle diameter of the metal-based particle, as referred to herein, is obtained as follows: a metal-based particle assembly (film) having metal-based particles disposed in two dimensions is observed with an SEM from directly above to obtain an SEM image thereof, and therein ten particles are selected at random and in each particle's image 5 tangential diametrical lines are drawn at random (note that the straight lines serving as the tangential diametrical lines can pass through only inside the image of the particle and one of the lines is a straight line passing through only inside the particle and drawable to be the longest) and their average value serves as the particle's diameter and the 10 selected particles' respective such particle diameters are averaged to obtain the average particle diameter of the metal-based particle. The tangential diametrical line is defined as a perpendicular line connecting a spacing between two parallel lines sandwiching the particle's contour (in a projected image) in contact therewith (see the Nikkan Kogyo Shimbun, Ltd., "Particle Measurement Technique", 1994, page 5).

The metal-based particle has an average height within a range of 55-500 nm, and to effectively obtain the effects of items (1) to (3) it falls within a range preferably of 55-300 nm, more preferably 70-150 nm. The average height of the metal-based particle is obtained as follows: the metal-based particle assembly layer (or film) is observed with an AFM to obtain an AFM image thereof and therein 10 particles are selected at random and measured in height and their measurements are averaged to obtain the average height.

The metal-based particle has an aspect ratio within a range of 1-8 and to effectively obtain the effects of items (1) to (3) it falls within a range preferably of 2-8, more preferably 2.5-8. The aspect ratio of the metal-based particle is defined as a ratio of the above average particle diameter to the above average height (i.e., average particle diameter/average height). While the metal-based particle may be spherical, preferably it is oblate having an aspect ratio exceeding one.

While the metal-based particle preferably has a smoothly curved surface in view of exciting significantly effective plasmon and it is more preferable that the metal-based particle be oblate having a smoothly curved surface, the metal-based particle may have a surface with small recesses and projections (or roughness) to some extent and in that sense the metal-based particle may be indefinite in shape.

Preferably, the metal-based particles have variation therebetween in size as minimal as possible in view of uniformity in intensity of plasmon resonance within a plane of the metal-based particle assembly layer. Even if there is a small variation in particle diameter, it is not preferable that large-size particles have an increased distance therebetween and it is preferable that particles of small size be introduced between the large-size particles to help the large-size particles to exhibit their interaction.

The metal-based particle assembly layer according to the present embodiment has adjacent metal-based particles disposed to have an average distance therebetween (hereinafter also referred to as average interparticle distance) within a range of 1-150 nm. Such closely disposed metal-based particles can realize significantly intense plasmon resonance and plasmon resonance having an effect over a significantly extended range, and furthermore, the effect of item (3). The average distance is preferably within a range of 1-100 nm, more preferably 1-50 nm, still more preferably 1-20 nm to effectively obtain the effects of items (1) to (3). An average interparticle distance smaller than 1 nm results in occurrence of electron transfer between the particles attributed to the Dexter mechanism, which disadvantageously deactivates localized plasmon.

The average interparticle distance, as referred to herein, is obtained as follows. A metal-based particle assembly layer having metal-based particles disposed in two dimensions is observed with an SEM from directly above to obtain an SEM image thereof, and therein 30 particles are selected at random and for each selected particle an interparticle distance to an adjacent particle is obtained and the 30 particles' such interparticle distances are averaged to obtain an average interparticle distance. In obtaining an interparticle distance to an adjacent particle, a distance to any adjacent particle, as obtained between their surfaces, is measured, and such measurements are averaged to obtain the interparticle distance.

The metal-based particle assembly layer includes 30 or more metal-based particles, preferably 50 or more metal-based particles. 30 or more metal-based particles assembled together have their localized plasmons interacting with each other and thus exhibit significantly intense plasmon resonance and plasmon resonance having an effect over a significantly extended range.

In light of a typical device area of the organic EL device, the metal-based particle assembly can include 300 or more metal-based particles, and furthermore, 17500 or more metal-based particles, for example.

The metal-based particle assembly layer includes metal-based particles having a number density preferably of 7 particles/$\mu$m² or larger, more preferably 15 particles/$\mu$m² or larger.

The metal-based particle assembly layer preferably has metal-based particles insulated from each other, that is, the layer is non-conductive between adjacent metal-based particles (or the layer is non-conductive). If some or all of the metal-based particles can pass/receive electrons to/from each other, the plasmon peak loses sharpness and thus resembles an absorption spectrum of bulk metal, and high plasmon resonance is not obtained, either. Accordingly, it is preferable that the metal-based particles be surely separated and have no conductive substance interposed therebetween.

Second Embodiment

The present embodiment provides an organic EL device including a metal-based particle assembly layer showing in an absorption spectrum for a visible light region a maximum wavelength of a peak at a longest side in wavelength, and the maximum wavelength shifts toward a shorter side in wavelength in a range of from 30 to 500 nm as compared with that of the reference metal-based particle assembly (X) (or having the feature indicated above at item [ii]). The organic EL device of the present embodiment including a metal-based particle assembly layer having such a feature is significantly advantageous as follows.

(I) The metal-based particle assembly layer according to the present embodiment shows in an absorption spectrum for the visible light region a maximum wavelength of a plasmon peak at a longest side in wavelength, and the maximum wavelength presents in a unique wavelength range, thereby allowing light emission of a specific (or desired) wavelength range to be particularly enhanced. Specifically, when the metal-based particle assembly layer according to the present embodiment is subjected to absorption spectrum measurement, it presents the plasmon peak with a maximum wavelength shifted to a shorter side (or blue-shifted) in wavelength in a range of 30-500 nm (e.g., 30-250 nm) as compared with a maximum wavelength of reference metal-based particle assembly (X) described later, and typically the plasmon peak has the maximum wavelength within a range of 350-500 nm.

It is believed that the blue shift as described above is attributed to the fact that the metal-based particle assembly layer is structured with at least a specific number of large-size metal-based particles each having a specific shape separated in two dimensions, followed by the metal-based particles having their localized plasmons interacting with each other.

The metal-based particle assembly layer according to the present embodiment having a plasmon peak in a blue wavelength range or a range close thereto is significantly useful in enhancing emission of an organic EL device using an organic luminescent material having a blue wavelength range or a range close thereto, and an organic EL device including such a metal-based particle assembly layer can provide sufficiently enhanced luminous efficiency even when it includes a blue luminescent organic material of relatively low luminous efficiency.

When a metal-based particle assembly and reference metal-based particle assembly (X) are observed to compare the maximum wavelengths of their peaks at a longest side in wavelength and the absorbances at the maximum wavelengths, a microscope ("OPTIPHOT-88" produced by Nikon) and a spectrophotometer ("MCPD-3000" produced by Otsuka Electronics Co., Ltd.) are used to perform absorption spectrum measurement in a narrowed field of view.

Reference metal-based particle assembly (X) is a metal-based particle assembly in which metal-based particles A that have a particle diameter and a height equal to the average particle diameter and the average height of a metal-based particle assembly layer subject to absorption spectrum measurement and are identical in material to the metal-based particles of the metal-based particle assembly layer are disposed such that each distance between adjacent metal-based particles may be in a range of from 1 to 2 $\mu$m, and reference metal-based particle assembly (X) has a size allowing reference metal-based particle assembly (X) layered on a glass substrate to undergo absorption spectrum measurement via a microscope, as described above.

The wave pattern of reference metal-based particle assembly (X)'s absorption spectrum is also theoretically calculatable in the 3D-FDTD method using the particle diameter and height of metal-based particle A, the dielectric function of a material of metal-based particle A, the dielectric function of a medium (e.g., air) surrounding metal-based particle A, and the dielectric function of the substrate (e.g., a glass substrate).

Furthermore, as the organic EL device of the present embodiment has a metal-based particle assembly layer structured with at least a specific number of metal-based particles of a relatively large size having a specific shape separated in two dimensions, (II) the metal-based particle assembly layer can exhibit significantly intense plasmon resonance and thus allows a stronger emission enhancement effect than a conventional plasmonic material, and hence drastically increased luminous efficiency, which is similar to effect (1) of the first embodiment, and (III) the metal-based particle assembly layer can present plasmon resonance having an effect over a significantly extended range (or a plasmonic enhancement effect covering the range) and thus allows a stronger emission enhancement effect than a conventional plasmonic material, and can similarly contribute to drastically increased luminous efficiency, which is similar to effect (2) of the first embodiment, and the like. When the metal-based particle assembly layer according to the present embodiment that is layered on a glass substrate is subjected to absorption spectrum measurement, it can present for the visible light region a maximum wavelength of a plasmon peak at a longest side in wavelength, and an absorbance at the maximum wavelength can be 1 or larger, further 1.5 or larger, and still further approximately 2.

Hereinafter will be described a specific configuration of the metal-based particle assembly layer according to the present embodiment. The metal-based particle assembly layer according to the present embodiment can have a specific configuration (for the material, average particle diameter, average height, aspect ratio, average interparticle distance, and count of the metal-based particles, the metal-based particle assembly layer's non-conductance, and the like) basically similar to that of the metal-based particle assembly layer according to the first embodiment. Average particle diameter, average height, aspect ratio, and average interparticle distance are defined as in the first embodiment.

The metal-based particles have an average particle diameter within a range of 200-1600 nm, and to effectively obtain the effects of items (I) to (III) it falls within a range preferably of 200-1200 nm, more preferably 250-500 nm, still more preferably 300-500 nm. The metal-based particle assembly layer according to the present embodiment is an assembly of at least a specific number of (30) large-size metal-based particles disposed in two dimensions and thus can realize significantly intense plasmon resonance and plasmon resonance having an effect over a significantly extended range. Furthermore, to also present the feature of item [ii] (i.e., a plasmon peak shifted to a shorter side in wavelength), it is essential that the metal-based particle has a large size with an average particle diameter of 200 nm or larger, preferably 250 nm or larger.

The metal-based particle assembly layer according to the present embodiment shows for a visible light region a maximum wavelength of a plasmon peak at a longest side in wavelength, and the maximum wavelength depends on the metal-based particles' average particle diameter. More specifically, when the metal-based particles have an average particle diameter exceeding a certain value, the plasmon peak has the maximum wavelength shifting toward a shorter side in wavelength (or blue-shifted).

The metal-based particles have an average height within a range of 55-500 nm, and to effectively obtain the effects of items (I) to (III) it falls within a range preferably of 55-300 nm, more preferably 70-150 nm. The metal-based particle has an aspect ratio within a range of 1-8 and to effectively obtain the effects of items (I) to (III) it falls within a range preferably of 2-8, more preferably 2.5-8. While the metal-based particle may be spherical, preferably it is oblate having an aspect ratio exceeding one.

While the metal-based particle preferably has a smoothly curved surface in view of exciting significantly effective plasmon and in particular it is more preferable that the metal-based particle be oblate having a smoothly curved surface, the metal-based particle may have a surface with small recesses and projections (or roughness) to some extent and in that sense the metal-based particle may be indefinite in shape. Preferably, the metal-based particles have variation therebetween in size as minimal as possible in view of uniformity in intensity of plasmon resonance within a plane of the metal-based particle assembly layer. Note, however, that, as has been set forth above, even if there is a small variation in particle diameter, it is not preferable that large-size particles have an increased distance therebetween, but it is preferable that particles of small size be introduced between the large-size particles to help the large-size particles to exhibit their interaction.

Preferably, the metal-based particle assembly layer according to the present embodiment has adjacent metal-based particles disposed to have an average distance therebetween (or an average interparticle distance) within a range of 1-150 nm. More preferably, it is within a range of 1-100 nm, still more preferably 1-50 nm, particularly more preferably 1-20 nm. Such closely disposed metal-based particles present the metal-based particles' localized plasmons interacting with each other effectively and thus facilitate presenting the effects of items (I) to (III). As a maximum wavelength of the plasmon peak depends on the metal-based particles' average interparticle distance, the average interparticle distance can be adjusted to control to what extent a plasmon peak at a longest side in wavelength should be blue-shifted, and the plasmon peak's maximum wavelength. An average interparticle distance smaller than 1 nm results in occurrence of electron transfer between the particles attributed to the Dexter mechanism, which disadvantageously deactivates localized plasmon.

Another means other than the above means to present the feature of item [ii] (i.e., a plasmon peak shifted to a shorter side in wavelength) can for example be introducing between the metal-based particles a dielectric substance having a dielectric constant different from that of air, which is preferably a non-conductive substance, as will be described later.

The metal-based particle assembly layer includes 30 or more metal-based particles, preferably 50 or more metal-based particles. 30 or more metal-based particles assembled together present the metal-based particles' localized plasmons interacting with each other effectively and thus allow the feature of item [ii] and the effects of items (I) to (III) to be presented.

In light of a typical device area of the organic EL device, the metal-based particle assembly can include 300 or more metal-based particles, and furthermore, 17500 or more metal-based particles, for example.

The metal-based particle assembly layer includes metal-based particles having a number density preferably of 7 particles/$\mu$m$^2$ or larger, more preferably 15 particles/$\mu$m$^2$ or larger.

The metal-based particle assembly layer according to the present embodiment, as well as that of the first embodiment, preferably has metal-based particles insulated from each other, that is, the layer is non-conductive between adjacent metal-based particles (or the layer is non-conductive).

Third Embodiment

The present embodiment provides an organic EL device including a metal-based particle assembly layer showing in an absorption spectrum for a visible light region a maximum wavelength of a peak at a longest side in wavelength, and an absorbance at the maximum wavelength is higher as compared with that of reference metal-based particle assembly (Y), on the premise that the numbers of metal-based particles are the same. The organic EL device of the present embodiment including a metal-based particle assembly layer having such a feature is significantly advantageous in the following points.

(A) The metal-based particle assembly layer according to the present embodiment shows for a visible light region a maximum wavelength of a peak at a longest side in wavelength, or a plasmon peak, and an absorbance at the maximum wavelength is higher as compared with that of reference metal-based particle assembly (Y) that can be regarded as an assembly of metal-based particles simply assembled together without any interparticle interaction. Accordingly, the metal-based particle assembly layer exhibits significantly intense plasmon resonance, and thus allows a stronger emission enhancement effect than a conventional plasmonic material, and hence drastically increased luminous efficiency. It is believed that such intense plasmon resonance is exhibited as the metal-based particles present localized plasmons interacting with each other.

As has been described above, the plasmon peak's absorbance value in magnitude at the maximum wavelength thereof can be used to easily evaluate the plasmonic material's plasmon resonance in intensity, and when the metal-based particle assembly layer according to the present embodiment that is layered on a glass substrate is subjected to absorption spectrum measurement, it can present for a visible light region a maximum wavelength of a plasmon peak at a longest side in wavelength, and an absorbance at the maximum wavelength can be 1 or larger, further 1.5 or larger, and still further approximately 2.

As has been previously described, when a metal-based particle assembly and reference metal-based particle assembly (Y) are observed to compare the maximum wavelengths of their peaks at a longest side in wavelength and the absorbances at the maximum wavelengths, a microscope ("OPTIPHOT-88" produced by Nikon) and a spectrophotometer ("MCPD-3000" produced by Otsuka Electronics Co., Ltd.) are used to perform absorption spectrum measurement in a narrowed field of view.

Reference metal-based particle assembly (Y) is a metal-based particle assembly in which metal-based particles B that have a particle diameter and a height equal to the average particle diameter and average height of a metal-based particle assembly layer subject to absorption spectrum measurement and are identical in material to the metal-based particles of the metal-based particle assembly layer are disposed such that each distance between adjacent metal-based particles may be in a range of from 1 to 2 $\mu$m, and reference metal-based particle assembly (Y) has a size allowing reference metal-based particle assembly (Y) layered on a glass substrate to undergo absorption spectrum measurement via a microscope, as described above.

When the metal-based particle assembly layer subject to absorption spectrum measurement and reference metal-based particle assembly (Y) are compared in their absorbances at the maximum wavelengths of their peaks at a longest side in wavelength, an absorption spectrum of reference metal-based particle assembly (Y) as converted to have the same number of metal-based particles is obtained and an absorbance at a maximum wavelength of a peak in that absorption spectrum, which peak is present at a longest side in wavelength, is used as a target for comparison, as will be described hereinafter. Specifically, an absorption spectrum of the metal-based particle assembly and that of reference metal-based particle assembly (Y) are obtained and the absorbances at the maximum wavelengths of the peaks in the absorption spectra, which peaks are present at a longest side in wavelength, respectively, are divided by their respective coverages (i.e., the coverages of their respective substrates' surfaces by the metal-based particles), and the obtained values are compared.

Furthermore, as the organic EL device of the present embodiment has a metal-based particle assembly layer structured with at least a specific number of metal-based particles of a relatively large size having a specific shape separated in two dimensions, it can have such effects as follows: (B) the metal-based particle assembly layer presents plasmon resonance that can have an effect over a significantly extended range (or a plasmonic enhancement effect that can cover the range) and the layer thus allows a stronger emission enhancement effect than a conventional plasmonic material, and hence drastically increased luminous efficiency, as well as effect (2) of the first embodiment; (C) the metal-based particle assembly layer can exhibit a plasmon peak having a maximum wavelength uniquely shifted and thus allows emission of a specific (or desired) wavelength range to be particularly enhanced, as well as effect (3) of the first embodiment; and the like.

The metal-based particle assembly layer of the present embodiment (when it is layered on a glass substrate) can present in an absorption spectrum for a visible light region, as measured through absorptiometry, a maximum wavelength of a plasmon peak at a longest side in wavelength, and the maximum wavelength can be in a range of for example from 350 to 550 nm, depending on the metal-based particles' shape and interparticle distance. Furthermore, the metal-based particle assembly layer of the present embodiment can typically cause a blue shift of approximately 30-500 nm (e.g., 30-250 nm) as compared with that having metal-based particles with a sufficiently large interparticle distance (for example of 1 $\mu$m).

Hereinafter will be described a specific configuration of the metal-based particle assembly layer according to the present embodiment. The metal-based particle assembly layer according to the present embodiment can have a specific configuration (for the material, average particle diameter, average height, aspect ratio, average interparticle distance, and count of the metal-based particles, the metal-based particle assembly layer's non-conductance, and the like) basically similar to that of the metal-based particle assembly layer according to the first embodiment. Average particle diameter, average height, aspect ratio, and average interparticle distance are defined as in the first embodiment.

The metal-based particles have an average particle diameter within a range of 200-1600 nm, and to effectively obtain the feature of item [iii] (i.e., to have an absorbance at a maximum wavelength of a plasmon peak at a longest side in wavelength, which absorbance is larger than that of reference metal-based particle assembly (Y)), and furthermore the effects of items (A) to (C), it falls within a range preferably of 200-1200 nm, more preferably 250-500 nm, still more preferably 300-500 nm. Thus it is important to use relatively large-size metal-based particles, and at least a specific number of (30) such large-size metal-based particles disposed in two dimensions and thus assembled together can achieve significantly intense plasmon resonance and furthermore, plasmon resonance having an effect over a significantly extended range and a plasmon peak shifted to a shorter side in wavelength.

The metal-based particles have an average height within a range of 55-500 nm, and to effectively obtain the feature of item [iii] and furthermore, the effects of items (A) to (C), it falls within a range preferably of 55-300 nm, more preferably 70-150 nm. The metal-based particle has an aspect ratio within a range of 1-8 and to effectively obtain the feature of item [iii] and furthermore, the effects of items (A) to (C) it falls within a range preferably of 2-8, more preferably 2.5-8. While the metal-based particle may be spherical, preferably it is oblate having an aspect ratio exceeding one.

While the metal-based particle preferably has a smoothly curved surface in view of exciting significantly effective plasmon and in particular it is more preferable that the metal-based particle be oblate having a smoothly curved surface, the metal-based particle may have a surface with small recesses and projections (or roughness) to some extent and in that sense the metal-based particle may be indefinite in shape.

Preferably, the metal-based particle assembly layer is configured of as uniform metal-based particles as possible in size and shape (average particle diameter, average height, and aspect ratio), as such metal-based particles can effectively achieve the feature of item [iii].

More specifically, uniforming the metal-based particles in size and shape provides a sharp plasmon peak, followed by that an absorbance of a plasmon peak at a longest side in wavelength facilitates being higher than that of reference metal-based particle assembly (Y). Metal-based particles less varying in size and shape are also advantageous in view of uniformity in intensity of plasmon resonance within a plane of the metal-based particle assembly layer. Note, however, that, as has been set forth above, even if there is a small variation in particle diameter, it is not preferable that large-size particles have an increased distance therebetween, but it is preferable that particles of small size be introduced between the large-size particles to help the large-size particles to exhibit their interaction.

Preferably, the metal-based particle assembly layer according to the present embodiment has adjacent metal-based particles disposed to have an average distance therebetween (or an average interparticle distance) within a range of 1-150 nm. More preferably, it is within a range of 1-100 nm, still more preferably 1-50 nm, particularly more preferably 1-20 nm. Such closely disposed metal-based particles present the metal-based particles' localized plasmons interacting with each other effectively and thus allow the feature of item [iii] and furthermore, the effects of items (A) to (C) to be effectively presented. An average interparticle distance smaller than 1 nm results in occurrence of electron transfer between the particles attributed to the Dexter mechanism, which disadvantageously deactivates localized plasmon.

The metal-based particle assembly layer includes 30 or more metal-based particles, preferably 50 or more metal-based particles. 30 or more metal-based particles assembled together present the metal-based particles' localized plasmons interacting with each other effectively and thus allow the feature of item [iii] and furthermore, the effects of items (A) to (C) to be effectively presented.

In light of a typical device area of the organic EL device, the metal-based particle assembly can include 300 or more metal-based particles, and furthermore, 17500 or more metal-based particles, for example.

The metal-based particle assembly layer includes metal-based particles having a number density preferably of 7 particles/$\mu$m$^2$ or larger, more preferably 15 particles/$\mu$m$^2$ or larger.

The metal-based particle assembly layer according to the present embodiment, as well as that of the first embodiment, preferably has metal-based particles insulated from each other, that is, the layer is non-conductive between adjacent metal-based particles (or the layer is non-conductive).

Thus the metal-based particle assembly layer according to the present embodiment having the feature of item [iii] can be obtained by controlling its constituent metal-based particles in metal type, size, shape, interparticle distance, and the like.

The metal-based particle assembly layer that the organic EL device of the present invention includes preferably has the feature of any one of items [i]-[iii], more preferably any two or more thereof, and still more preferably all thereof.

<Method for Producing Metal-Based Particle Assembly Layer>

A metal-based particle assembly layer according to the present invention including the metal-based particle assembly layers according to the first to third embodiments can be produced in such a method as follows:

(1) a bottom-up method to grow metal-based particles from minute seeds on a substrate;
(2) a method in which a metal-based particle that has a prescribed shape is covered with a protection layer made of an amphiphilic material and having a prescribed thickness, and the resultant is then subjected to langmuir blodgett (LB) deposition to be formed in a film on a substrate; and
(3) other methods, such as a method of post-treating a thin film obtained by vapor deposition, sputtering or the like; resist-processing; etching processing; a casting method using a liquid having metal-based particles dispersed therein, and the like.

It is important that method (1) includes the step of growing a metal-based particle at a significantly low speed on a substrate adjusted to have a prescribed temperature (hereinafter also referred to as the particle growth step). A production method including the particle growth step can provide a satisfactorily controlled layer (or thin film) of a metal-based particle assembly having 30 or more metal-based particles mutually separated and thus disposed in two dimensions, and having a shape within a prescribed range (an average particle diameter of 200 to 1600 nm, an average height of 55 to 500 nm, and an aspect ratio of 1 to 8) and still preferably an average interparticle distance within a prescribed range (1-150 nm).

In the particle growth step, the metal-based particle is grown on the substrate preferably at an average height growth rate smaller than 1 nm/minute, more preferably 0.5 nm/minute or smaller. The average height growth rate as referred to herein can also be referred to as an average deposition rate or the metal-based particle's average thickness growth rate, and is defined by the following expression:

metal-based particle's average height / metal-based particle growth time (supplying time of a metal-based material).

The "metal-based particle's average height" is defined as set forth above.

In the particle growth step, the substrate is set in temperature preferably within a range of 100-450°C, more preferably 200-450°C, still more preferably 250-350°C, and particularly still more preferably 300°C or therearound (300°C ± approximately 10°C).

When the production method includes the particle growth step to grow metal-based particles at an average height growth rate smaller than 1 nm/minute on a substrate adjusted in temperature within the range of 100-450°C, the particles are initially grown such that a supplied metal-based material forms a plurality of island structures, and as the metal-based material is further supplied the island structures are further grown and thus merged with neighboring island structures, and consequently, metal-based particles having a relatively large average particle diameter are closely disposed while metal-based particles each are completely separated from each other to form a metal-based particle assembly layer. Thus, a metal-based particle assembly layer can be produced that is formed of metal-based particles controlled to have a shape within a prescribed range (in average particle diameter, average height, and aspect ratio) and still preferably an average interparticle distance within a prescribed range.

Furthermore, the average height growth rate, the substrate's temperature and/or the metal-based particle growth time (the supplying time of the metal-based material) can be adjusted to also control within a prescribed range the average particle diameter, the average height, the aspect ratio, and/or the average interparticle distance of the metal-based particles grown on the substrate.

Furthermore, the production method including the particle growth step also allows the particle growth step to be performed such that conditions other than the substrate's temperature and the average height growth rate are selected relatively freely, and the method thus also advantageously allows a metal-based particle assembly layer of a desired size to be efficiently formed on a substrate of a desired size.

If the average height growth rate is 1 nm/minute or larger, or the substrate has a temperature lower than 100°C or higher than 450°C, then before the island structure is grown to be large the island structure forms a continuum with a neighboring island structure and a metal-based assembly formed of metal-based particles mutually completely separated and having a large particle diameter cannot be obtained or a metal-based assembly formed of metal-based particles having a desired shape cannot be obtained (for example, it would depart in average height, average interparticle distance, and aspect ratio from a desired range).

While the metal-based particles are grown under a pressure (in an apparatus's chamber), which may be any pressure that allows the particles to be grown, it is normally lower than atmospheric pressure. While the pressure's lower limit is not limited to a specific value, it is preferably 6 Pa or larger, more preferably 10 Pa or larger, still more preferably 30 Pa or larger, as such pressure helps to adjust the average height growth rate within the range indicated above.

The metal-based particles can specifically be grown on a substrate in any method allowing the particles to be grown at an average height growth rate smaller than 1 nm/minute, and the method can include sputtering, and vapor deposition such as vacuum deposition. Preferable sputtering is direct current (DC) sputtering as it allows a metal-based particle assembly layer to be grown relatively conveniently and also facilitates maintaining the average height growth rate smaller than 1 nm/minute. The sputtering may be done in any system and it can for example be an ion gun, or be direct current argon ion sputtering to expose a target to argon ions generated by a plasma discharge and accelerated in an electric field. The sputtering is done with a current value, a voltage value, a substrate-to-target distance and other conditions adjusted as appropriate to grow particles at the average height growth rate smaller than 1 nm/minute.

Note that to obtain a satisfactorily controlled metal-based particle assembly layer formed of metal-based particles having a shape within a prescribed range (in average particle diameter, average height, and aspect ratio) and still preferably an average interparticle distance within a prescribed range, it is preferable that the particle growth step be performed at the average height growth rate smaller than 1 nm/minute and in addition thereto an average particle diameter growth rate smaller than 5 nm, and when the average height growth rate is smaller than 1 nm/minute, the average particle diameter growth rate is normally smaller than 5 nm. The average particle diameter growth rate is more preferably 1 nm/minute or smaller. The average particle diameter growth rate is defined by the following expression:
metal-based particle's average particle diameter / metal-based particle growth time (supplying time of a metal-based material).
The "metal-based particle's average particle diameter" is defined as set forth above.

The metal-based particle growth time (the supplying time of a metal-based material) in the particle growth step is a period of time that at least allows metal-based particles carried on a substrate to attain a shape within a prescribed range and still preferably an average interparticle distance within a prescribed range and that is smaller than a period of time allowing the particles to depart from the shape within the prescribed range and the average interparticle distance within the prescribed range. For example, even though particle growth is performed at an average height growth rate and substrate temperature within the above prescribed ranges, an extremely long period of time for growth results in a metal-based material carried in an excessively large amount and accordingly it will not form an assembly of mutually separated metal-based particles and instead form a continuous film or be metal-based particles excessively large in average particle size or average height.

Accordingly it is necessary to grow metal-based particles for an appropriately set period of time (or to stop the particle growth step at an appropriate time), and such time can be set based for example on a relationship between an average height growth rate and a substrate's temperature and a shape and average interparticle distance of metal-based particles of a metal-based particle assembly obtained, as previously obtained through an experiment. Alternatively a time elapsing before a thin film of a metal-based material grown on a substrate exhibits conduction, that is, a time allowing the thin film to be a continuous film rather than a metal-based particle assembly film, may previously be obtained through an experiment and the particle growth step may be stopped before that time is reached.

The metal-based particles are grown on a substrate preferably having as smooth a surface as possible and, inter alia, more preferably a surface that is smooth at the atomic level. When the substrate has a smoother surface, thermal energy received from the substrate helps a growing metal-based particle to merge with a surrounding, adjacent metal-based particle and thus grow, and thus there is a tendency to facilitate providing a film formed of metal-based particles of a larger size.

The substrate on which the metal-based particles are grown can exactly be used as a substrate of the organic EL device. That is, a substrate having a metal-based particle assembly layer layered or carried thereon, as produced in the above method, (i.e., a metal-based particle assembly layer-layered substrate) can be used as a constituent member of the organic EL device.

<Configuration of Organic EL Device>

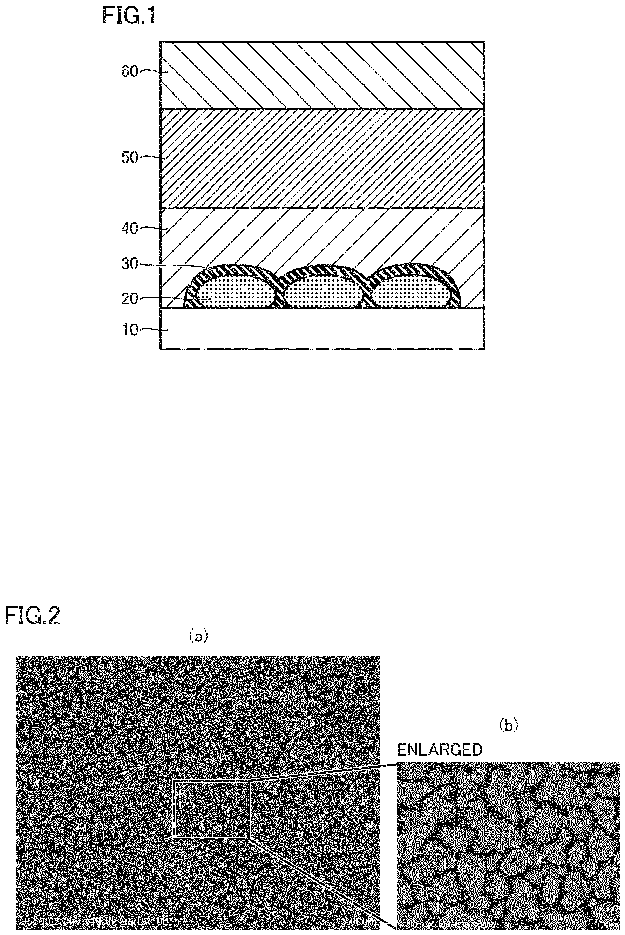

Fig. 1 is a schematic cross section view of an example for an organic EL device of the present invention. As shown in Fig. 1, the organic EL device of the present invention at least includes: a pair of a first electrode layer 40 (e.g., an anode) and a second electrode layer 60 (e.g., a cathode); a light emitting layer 50 disposed between first electrode layer 40 and second electrode layer 60, and containing an organic luminescent material; and a metal-based particle assembly layer that is a layer (or film) consisting of a particle assembly disposed in the organic EL device and formed of 30 or more metal-based particles 20 mutually separated and disposed in two dimensions. As well as a typical organic EL device, the organic EL device of the present invention can be such constituent layers as described above that are layered on a substrate 10.

While the metal-based particle assembly layer can be disposed at any position in the organic EL device, the layer is preferably disposed closer to a light extraction face than the light emitting layer, more preferably in a vicinity of the light extraction face. As has been set forth above, the present invention allows a metal-based particle assembly layer to present plasmon resonance to have an effect over a significantly extended range, and accordingly allows the metal-based particle assembly layer to be disposed at such a position while ensuring a high emission enhancement effect. The metal-based particle assembly layer disposed closer to the light extraction face allows more improved light extraction efficiency and hence more improved luminous efficiency. The plasmonic material, or the metal-based particle assembly layer, disposed in the organic EL device is advantageous in increasing the durability of the organic luminescent material of the light emitting layer, as the metal-based particle assembly layer, receiving energy transferred from the organic luminescent material of the light emitting layer, will have a role of emission.

For example, the organic EL device in one preferable configuration includes substrate 10, a metal-based particle assembly layer, first electrode layer 40, light emitting layer 50, and second electrode layer 60 in this order, as shown in Fig. 1. When such a configuration has substrate 10 that is an (optically) transparent substrate, the configuration allows a light extraction face to be provided at a side of the substrate opposite to a side thereof provided with the metal-based particle assembly layer (e.g., the substrate's back surface (a surface of the substrate opposite to a side thereof provided with the metal-based particle assembly layer) can serve as the light extraction face), and thus allows a configuration with the metal-based particle assembly layer disposed in a vicinity of the light extraction face.

In the organic EL device shown in Fig. 1, the metal-based particle assembly layer can be layered directly on (or carried directly on) substrate 10, and the metal-based particle assembly layer and substrate 10 thus stacked in layers can preferably be implemented by the metal-based particle assembly layer-layered substrate that can be produced in the above described method.

While substrate 10 may be formed of any material, it is preferable that the substrate be a non-conductive substrate to ensure that the metal-based particle assembly layer is non-conductive especially when the metal-based particle assembly layer is layered directly on substrate 10. The non-conductive substrate can be formed of glass, a variety of inorganic insulating materials ($SiO_2$, $ZrO_2$, mica, and the like), and a variety of plastic materials. As has previously been described, substrate 10 is preferably optically transparent.

As shown in Fig. 1, the organic EL device of the present invention preferably further includes an insulating layer 30 covering a surface of each metal-based particle 20 configuring the metal-based particle assembly layer. Such insulating layer 30 can ensure that the metal-based particle assembly layer is non-conductive (or the metal-based particles are non-conductive therebetween) as described above, and insulating layer 30 also allows the metal-based particle assembly layer and an adjacent layer to be electrically insulated from each other. While the organic EL device has each constituent layer with a current passing therethrough, the metal-based particle assembly layer with a current passing therethrough may result in failing to obtain a sufficient emission enhancement effect via plasmon resonance. Providing insulating layer 30 that caps the metal-based particle assembly layer allows a metal-based particle assembly film and an adjacent layer to be electrically insulated from each other and can thus prevent a current from being injected into the metal-based particles that compose the metal-based particle assembly.

Insulating layer 30 is formed of any material that is not specially restricted as long as having satisfactory insulation, and it can be formed for example of spin on glass (SOG; containing organic siloxane material for example) and in addition thereto $SiO_2$, $Si_3N_4$ or the like. While insulating layer 30 is of any thickness that is not restricted as long as ensuring desired insulation, it is better that insulating layer 30 is smaller in thickness in a range ensuring desired insulation as it is preferable that light emitting layer 50 and the metal-based particle assembly layer be closer in distance, as will be described later.

Light emitting layer 50, first electrode layer 40, and second electrode layer 60 can be configured of material conventionally known in the field of art and may also have thickness that an organic EL device normally has. Light emitting layer 50 can contain an organic luminescent material that is for example an organic phosphorescence emission material (a phosphorescence emission polymer or the like), an organic fluorescence emission material (a fluorescence emission polymer or the like) or the like as conventionally known.

More specifically, light emitting layer 50 can for example be that formed of 1) a luminescent small molecule, 2) a luminescent polymer, or the like.

Light emitting layer 1) can be obtained through dry or wet deposition including spin-coating, vapor deposition or the like. The luminescent small molecule is specifically exemplified by tris (8-quinolinolato) aluminum complex [tris (8-hydroxyquinoline) aluminum complex; Alqs], bis(benzoquinolinolato)beryllium complex [BeBq], and the like.

Light emitting layer 2) can be obtained by a wet deposition using a luminescent polymer containing liquid such as spin-coating. The luminescent polymer is specifically exemplified by a $\pi$-conjugated polymer such as F8BT [poly(9,9-dioctylfluorene-alt-benzothiadiazole)], poly(p-phenylenevinylene), polyalkylthiophene, and the like.

The present invention includes a metal-based particle assembly layer presenting intense plasmon resonance and plasmon resonance having an effect over a significantly extended range (or a plasmonic enhancement effect covering the range), and thus allows a light emitting layer as a whole to provide enhanced emission and hence improved luminous efficiency, even when the light emitting layer has the thickness of for example 10 nm or larger, further 20 nm or larger, still further the thickness larger than that.

Furthermore, even when the organic EL of the present invention device employs a conventional blue luminescent organic material of relatively low luminous efficiency (or a luminescent organic material of a wavelength range close thereto), the organic EL device, including a metal-based particle assembly layer presenting a plasmon peak having a maximum wavelength shifted to a shorter side in wavelength, allows the luminescent organic material to have an extended durability and also achieve sufficiently enhanced luminous efficiency.

The organic EL device of the present invention is not specifically restricted in distance between light emitting layer 50 and the metal-based particle assembly layer (i.e., from a surface of the metal-based particle assembly layer closer to light emitting layer 50 to light emitting layer 50), and, as has been set forth above, the organic EL device with the metal-based particle assembly layer disposed at a position for example 10 nm, further several tens nm (e.g., 20 nm), still further several hundreds nm remote from light emitting layer 50 can still achieve an emission enhancement effect via plasmon resonance.

For example, even if the organic EL device of the present invention has light emitting layer 50 and the metal-based particle assembly layer with a distance of 20 nm or larger therebetween, it nonetheless allows the organic luminescent material contained in light emitting layer 50 to have a photoluminescence quantum efficiency (i.e., the number of discharged photons divided by that of absorbed photons) of 1.5 times or larger, furthermore, 3 times or larger than that of a reference organic EL device that does not have the metal-based particle assembly layer.

Note that there is a tendency that, for its nature, the plasmonic emission enhancement effect decreases as the distance between light emitting layer 50 and the metal-based particle assembly layer increases, so it is preferable that the distance be smaller. Light emitting layer 50 and the metal-based particle assembly layer have a distance therebetween preferably of 100 nm or smaller, more preferably 20 nm or smaller, and still more preferably 10 nm or smaller.

The organic EL device of the present invention can further include other layers, which are not shown, such as a hole injection layer, a hole transport layer, an electron transport layer, and an electron injection layer.

Preferably the metal-based particle assembly layer has a plasmon peak with a maximum wavelength matching or close to the emission wavelength of the organic luminescent material of light emitting layer 50. This allows plasmon resonance to contribute to a more effectively increased emission enhancement effect. The maximum wavelength of the plasmon peak of the metal-based particle assembly layer is controllable by adjusting the layer's constituent metal-based particles in metal type, average particle diameter, average height, aspect ratio, and/or average interparticle distance.

Examples

Hereinafter, examples will be described to more specifically describe the present invention, although the present invention is not limited thereto.

[Producing Metal-Based Particle Assembly Layer-Layered Substrate]

<Production Example 1>

A direct-current magnetron sputtering apparatus was used to grow silver particles significantly slowly on a soda glass substrate to form a thin film of a metal-based particle assembly on the entire surface of the substrate to produce a metal-based particle assembly layer-layered substrate under the following conditions:

gas used: argon;
pressure in chamber (sputtering-gas pressure): 10 Pa;
substrate-to-target distance: 100 mm;
sputtering power: 4 W;
average particle diameter growth rate (average particle diameter/sputtering time): 0.9 nm/minute;
average height growth rate (= average deposition rate = average height/sputtering time): 0.25 nm/minute;
substrate's temperature: 300°C; and
substrate's size and shape: a square with each side having a length of 5 cm.

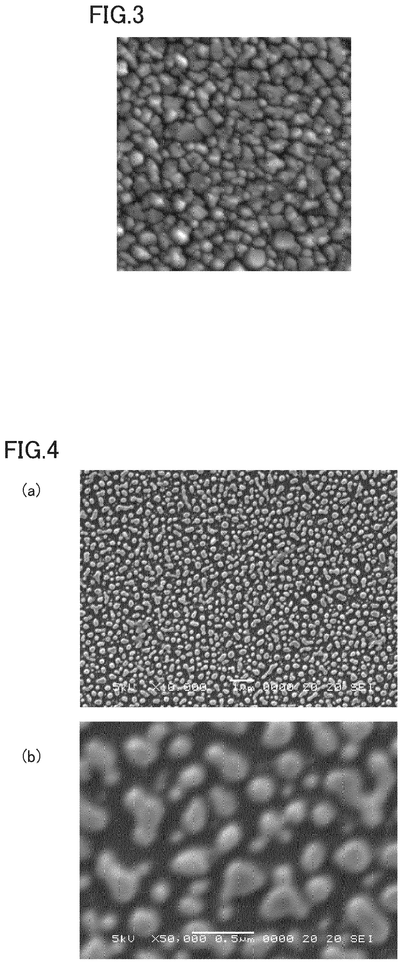

Fig. 2 is SEM images of a metal-based particle assembly layer in the obtained metal-based particle assembly layer-layered substrate, as observed from directly above. Fig. 2(a) is an image enlarged as scaled 10000 times and Fig. 2(b) is an image enlarged as scaled 50000 times. Fig. 3 is an AFM image of the metal-based particle assembly layer in the metal-based particle assembly layer-layered substrate obtained. The AFM image was obtained via "VN-8010" produced by KEYENCE CORPORATION (this is also applied hereinafter). Fig. 3 shows an image having a size of 5 $\mu$m × 5 $\mu$m.

A calculation with reference to the Fig. 2 SEM images indicates that the present production example provided a metal-based particle assembly layer configured of silver particles having an average particle diameter of 335 nm and an average interparticle distance of 16.7 nm, as based on the definition indicated above. Furthermore, from the Fig. 3 AFM image, an average height of 96.2 nm was obtained. From these values the silver particle's aspect ratio (average particle diameter/average height) was calculated to be 3.48 and it can also be found from the obtained images that the silver particles have an oblate shape. Furthermore, it can be seen from the SEM images that the metal-based particle assembly layer of this production example has approximately 6.25 × 10$^{10}$ silver particles (approximately 25 particles/$\mu$m2).

Furthermore, the obtained metal-based particle assembly layer-layered substrate had the metal-based particle assembly layer connected at a surface to a tester [multimeter "E2378A" produced by Hewlett Packard Co.] to confirm conduction, and it has been found to be non-conductive.

<Production Example 2>

An aqueous silver nanoparticle dispersion (produced by Mitsubishi Paper Mills, Ltd., silver nanoparticle concentration: 25% by weight) was diluted with pure water to have a silver nanoparticle concentration of 2% by weight. Then to the aqueous silver nanoparticle dispersion 1% by volume of a surfactant was added and sufficiently agitated and thereafter to the obtained aqueous silver nanoparticle dispersion 80% by volume of acetone was added and sufficiently agitated at ordinary temperature to prepare a silver nanoparticle coating liquid.

Then, the silver nanoparticle coating liquid was applied with spin-coating at 1000 rpm on a 1 mm thick soda glass substrate having a surface wiped with acetone and thereafter the substrate was left as it is in the atmosphere for 1 minute and subsequently annealed in an electric furnace of 550°C for 40 seconds. A silver nanoparticle layer was thus formed, and on the nanoparticle layer the silver nanoparticle coating liquid was again applied with spin-coating at 1000 rpm and thereafter left as it is in the atmosphere for 1 minute and subsequently annealed in an electric furnace of 550°C for 40 seconds to obtain a metal-based particle assembly layer-layered substrate.

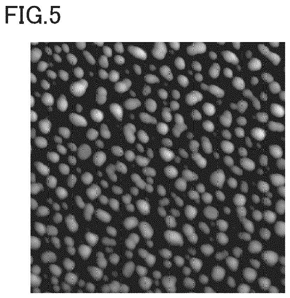

Fig. 4 is SEM images of a metal-based particle assembly layer in the obtained metal-based particle assembly layer-layered substrate, as observed from directly above. Fig. 4(a) is an image enlarged as scaled 10000 times and Fig. 4(b) is an image enlarged as scaled 50000 times. Fig. 5 is an AFM image of the metal-based particle assembly layer in the metal-based particle assembly layer-layered substrate obtained. Fig. 5 shows an image having a size of 5 $\mu$m × 5 $\mu$m.

A calculation with reference to the Fig. 4 SEM images indicates that the present production example provided a metal-based particle assembly layer configured of silver particles having an average particle diameter of 293 nm and an average interparticle distance of 107.8 nm, as based on the definition indicated above. Furthermore, from the Fig. 5 AFM image, an average height of 93.0 nm was obtained. From these values the silver particle's aspect ratio (average particle diameter/average height) was calculated to be 3.15 and it can also be found from the obtained images that the silver particles have an oblate shape. Furthermore, it can be seen from the SEM images that the metal-based particle assembly layer of this production example has approximately 3.13 × 10$^{10}$ silver particles (approximately 12.5 particles/$\mu$m2).

Furthermore, the obtained metal-based particle assembly layer-layered substrate had the metal-based particle assembly layer connected at a surface to a tester [multimeter "E2378A" produced by Hewlett Packard Co.] to confirm conduction, and it has been found to be non-conductive.

<Comparative Production Examples 1 and 2>

The direct-current magnetron sputtering was done with a varied deposition time to produce metal-based particle assembly layer-layered substrates of Comparative Production Examples 1 and 2. The metal-based particle assembly layer-layered substrate of Comparative Production Example 1 had metal-based particles having approximately the same shape, aspect ratio and average interparticle distance as Production Example 1 except that the metal-based particles had an average height of approximately 10 nm, and the metal-based particle assembly layer-layered substrate of Comparative Production Example 2 had metal-based particles having approximately the same shape, aspect ratio and average interparticle distance as Production Example 1 except that the metal-based particles had an average height of approximately 30 nm.

[Measuring Absorption Spectrum of Metal-Based Particle Assembly Layer-Layered Substrate]

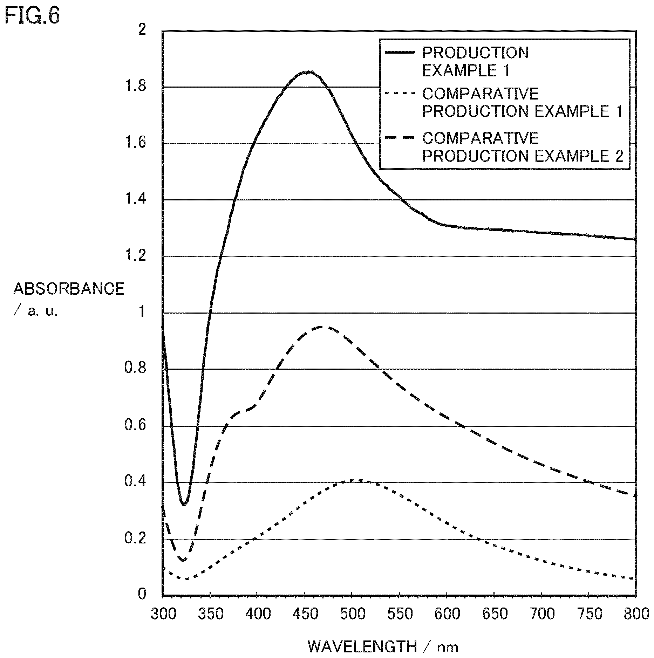

Fig. 6 represents absorption spectra, as measured through absorptiometry, of the metal-based particle assembly layer-layered substrates obtained in Production Example 1 and Comparative Production Examples 1 and 2. As indicated in a nonpatent document (K. Lance Kelly, et al., "The Optical Properties of Metal Nanoparticles: The Influence of Size, Shape, and Dielectric Environment", The Journal of Physical Chemistry B, 2003, 107, 668), an oblate silver particle as produced in Production Example 1 alone typically has a plasmon peak around 550 nm and 650 nm for average particle diameters of 200 nm and 300 nm, respectively.

In contrast, it can be seen that Production Example 1's metal-based particle assembly layer-layered substrate, with its constituent silver particles having an average particle diameter of approximately 300 nm (335 nm), nonetheless presents for a visible light region a maximum wavelength of a plasmon peak at a longest side in wavelength, and the maximum wavelength is around approximately 450 nm, or shifted to a shorter side in wavelength, as shown in Fig. 6. This phenomenon can be manifested when the silver particles are large-size particles having the above prescribed shape and also have the above prescribed average interparticle distance and are disposed significantly closely, as provided in Production Example 1. Such a phenomenon would not rationally be understandable without considering that the particles that are closely adjacent allow their respective, internally caused plasmons to interact with each other.

Furthermore, the plasmon peak's maximum wavelength also depends on the metal-based particles' average particle diameter. For example, Comparative Production Examples 1 and 2 have small average particle diameters, and accordingly have a plasmon peak at a side considerably longer in wavelength than Production Example 1, with maximum wavelengths of approximately 510 nm and approximately 470 nm, respectively.

Furthermore, Production Example 1 shows for the visible light region a maximum wavelength of a peak at a longest side in wavelength, and an absorbance at the maximum wavelength is approximately 1.9, which is significantly higher than Comparative Production Examples 1 and 2 and it can be seen therefrom that Production Example 1 provides a metal-based particle assembly layer presenting significantly intense plasmon resonance.

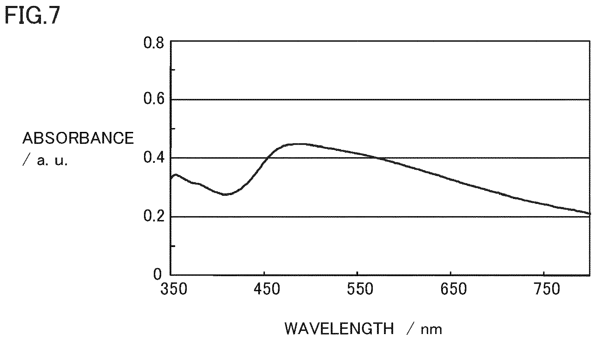

Fig. 7 represents an absorption spectrum, as measured through absorptiometry, of a metal-based particle assembly layer-layered substrate obtained in Production Example 2. It presented for the visible light region a maximum wavelength of a plasmon peak at a longest side in wavelength, and the maximum wavelength was 488 nm.

Note that the Figs. 6 and 7 absorption spectra are obtained as follows: a metal-based particle assembly layer-layered substrate is exposed to light of the ultraviolet to visible light region incident on a back surface thereof (i.e., a side opposite to the metal-based particle assembly layer) in a direction perpendicular to a substrate surface and intensity I of transmitted light omnidirectionally transmitted toward the metal-based particle assembly layer is measured with an integrating sphere spectrophotometer. On the other hand, a substrate which does not have a metal-based particle assembly film and has the same thickness and the same material as the substrate of said metal-based particle assembly film-layered substrate is exposed at a surface thereof to the same incident light as above in a direction perpendicular to that surface and intensity $I_0$ of transmitted light omnidirectionally transmitted through a side opposite to the incident surface is measured with the integrating sphere spectrophotometer. The axis of ordinate represents absorbance, which is represented by the following expression:

$$\text{Absorbance} = - \log_{10} (I/I_0).$$

[Producing Reference Metal-Based Particle Assembly and Measuring Absorption Spectrum]

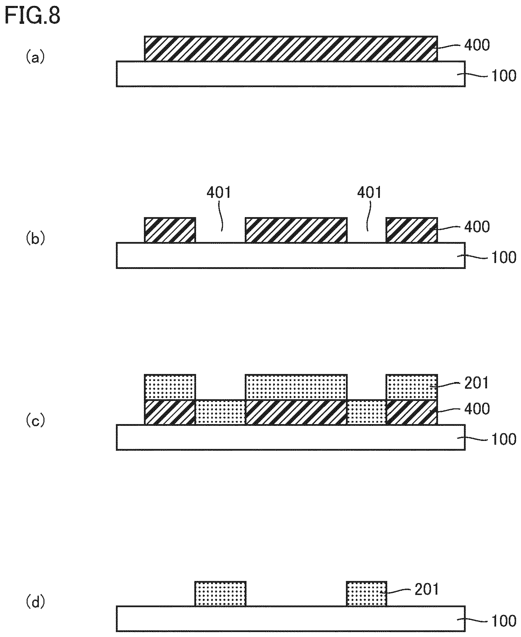

A method shown in Fig. 8 was used to produce a substrate having a reference metal-based particle assembly layered thereon. Initially, resist (ZEP520A produced by Nippon Zeon Co., Ltd.) was applied with spin-coating on an entire surface of a 5 cm long and 5 cm wide soda glass substrate 100 (see Fig. 8(a)). Resist 400 had the thickness of approximately 120 nm. Then electron beam lithography was employed to provide resist 400 with a circular opening 401 (see Fig. 8(b)). Circular opening 401 had a diameter of approximately 350 nm. Furthermore, adjacent circular openings 401 had a center-to-center distance of approximately 1500 nm.

Subsequently, resist 400 having circular opening 401 was subjected to vapor deposition to have a silver film 201 deposited thereon (see Fig. 8(c)). Silver film 201 had the thickness of approximately 100 nm. Finally, the substrate having silver film 201 was immersed in NMP (N-methyl-2-pyrrolidone produced by Tokyo Chemical Industry Co,. Ltd.), and settled in an ultrasonic device for one minute at room temperature to peel off resist 400 and silver film 201 deposited on resist 400, thereby obtaining a reference metal-based particle assembly layer-layered substrate in which only the silver film 201 (silver particles) in circular opening 401 was left and layered on soda glass substrate 100 (see Fig. 8(d)).

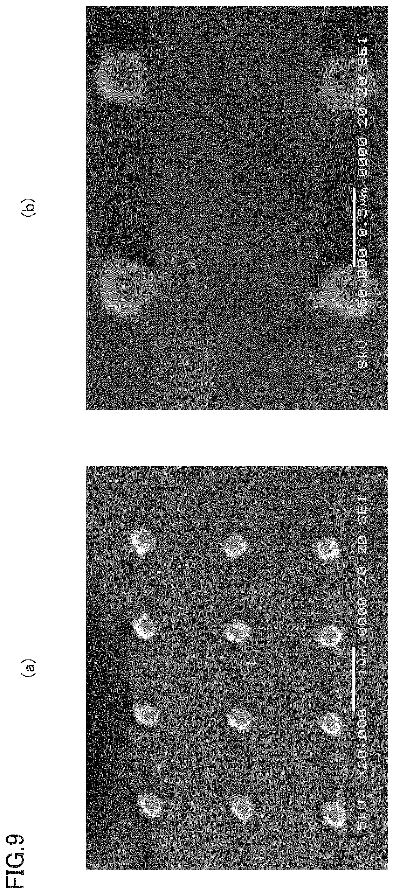

Fig. 9 is SEM images of a reference metal-based particle assembly layer in the obtained reference metal-based particle assembly layer-layered substrate, as observed from directly above. Fig. 9(a) is an image enlarged as scaled 20000 times and Fig. 9(b) is an image enlarged as scaled 50000 times. A calculation with reference to the Fig. 9 SEM images indicates that the reference metal-based particle assembly layer was configured of silver particles having an average particle diameter of 333 nm and an average interparticle distance of 1264 nm, as based on the definition indicated above. Furthermore, from a separately obtained AFM image, an average height of 105.9 nm was obtained. Furthermore, from the SEM images, it has been found that the reference metal-based particle assembly had approximately 62500 silver particles.

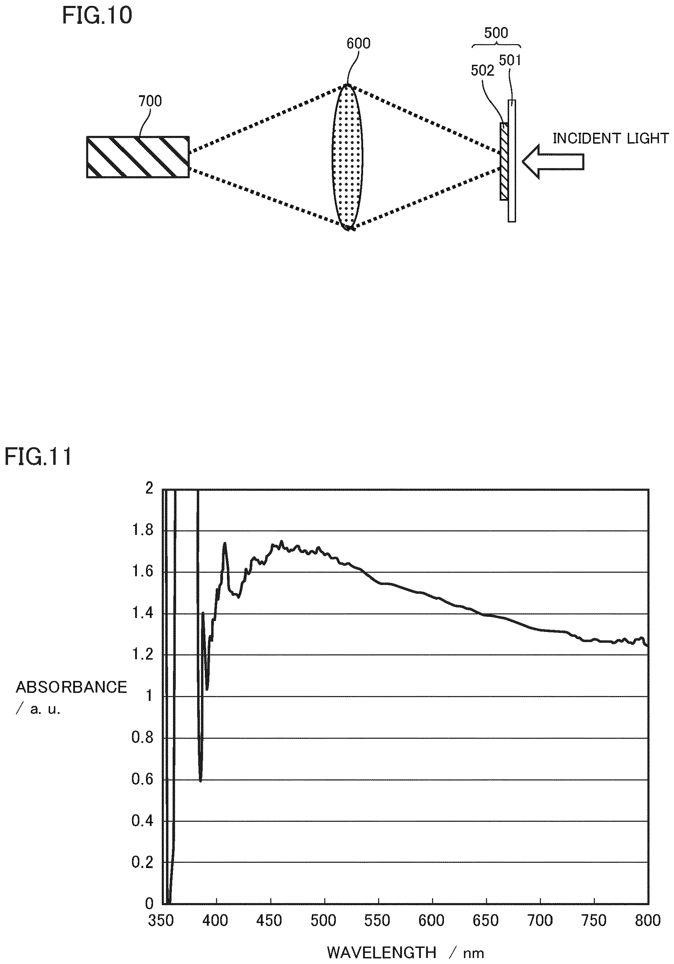

In accordance with the above described measurement method using a microscope's objective lens (100 times), absorption spectrum measurement was performed for the metal-based particle assembly layer-layered substrate of Production Example 1. More specifically, with reference to Fig. 10, a metal-based particle assembly film-layered substrate 500 had a substrate 501 exposed at a side thereof (a side opposite to a metal-based particle assembly film 502) to light of a visible light region incident thereon in a direction perpendicular to a substrate surface. The transmitted light that was transmitted to a side of metal-based particle assembly film 502 and reached an objective lens 600 of 100 times was condensed by objective lens 600 and detected via a spectrophotometer 700 to obtain an absorption spectrum.

For spectrophotometer 700 was used "MCPD-3000", a spectrophotometer produced by Otsuka Electronics Co., Ltd. for an ultraviolet and visible region, and for objective lens 600 was used "BD Plan 100/0.80 ELWD" produced by Nikon. The result is shown in Fig. 11. A plasmon peak at a longest side in wavelength for the visible light region had a maximum wavelength similar to that shown in the Fig. 6 absorption spectrum, i.e., approximately 450 nm. In contrast, when absorption spectrum measurement was performed for the reference metal-based particle assembly layer-layered substrate also in accordance with the measurement method using the microscope's objective lens, it presented for the visible light region a maximum wavelength of a peak at a longest side in wavelength, and the maximum wavelength was 654 nm. Production Example 1's metal-based particle assembly layer-layered substrate presents for the visible light region a maximum wavelength of a peak at a longest side in wavelength, and the maximum wavelength is blue-shifted by approximately 200 nm as compared with that of the reference metal-based particle assembly layer-layered substrate.

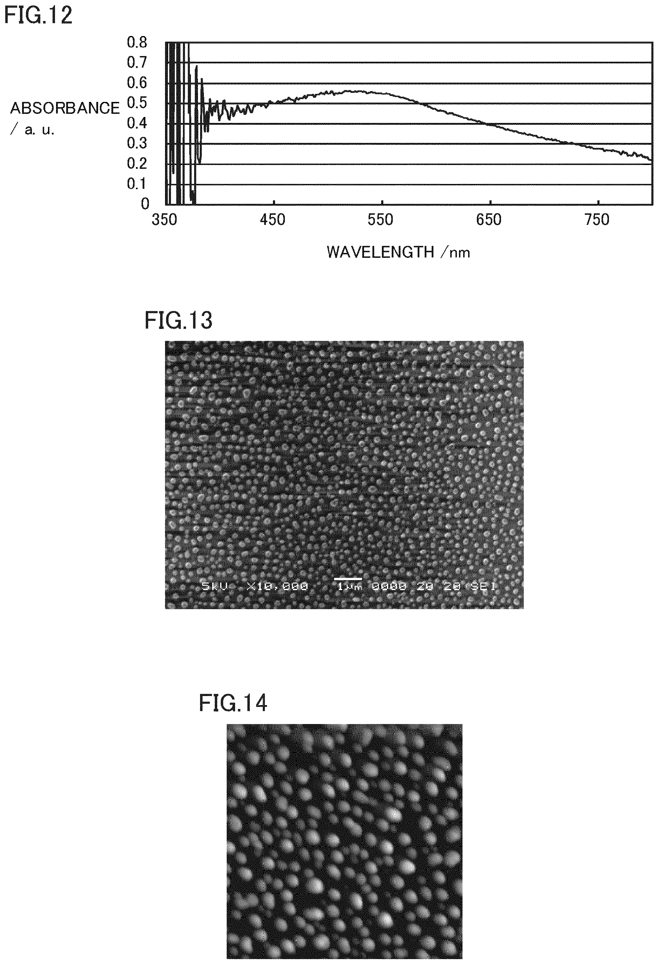

Fig. 12 is an absorption spectrum of the metal-based particle assembly film-layered substrate of Production Example 2, as measured in a method using an objective lens (100 times) of a microscope. The metal-based particle assembly of Production Example 2 has metal-based particles having a larger average particle diameter than that of Comparative Reference Example 1-1, and accordingly it is rationally inferred from the Mie-scattering theory that the metal-based particle assembly of Production Example 2 presents a plasmon peak appearing at a longer side in wavelength than that of Comparative Reference Example 1-1. In reality, however, the metal-based particle assembly of Production Example 2 has presented a plasmon peak at a shorter side in wavelength than that of Comparative Reference Example 1-1 by as much as 100 nm or larger. This rationally indicates that the metal-based particle assembly of Production Example 2 presents a plasmon peak with a maximum wavelength shifted toward a shorter side in wavelength than the reference metal-based particle assembly in a range of 30-500 nm.

The metal-based particle assembly layer-layered substrate of Production Example 1 presented for the visible light region a maximum wavelength of a peak at a longest side in wavelength, and an absorbance at the maximum wavelength was 1.744 (see Fig. 11), whereas the reference metal-based particle assembly layer-layered substrate presented an absorbance of 0.033. As the metal-based particle assembly layer-layered substrate of Production Example 1 and the reference metal-based particle assembly layer-layered substrate were examined to compare the absorbances at the maximum wavelengths of their peaks at a longest side in wavelength, they were compared for the same number of metal-based particles, and to do so, an absorbance obtained from an absorption spectrum was divided by a parameter corresponding to the number of metal-based particles, i.e., a coverage of a substrate's surface by the metal-based particles, to calculate absorbance/coverage. The metal-based particle assembly layer-layered substrate of Production Example 1 presented absorbance/coverage of 2.04 (coverage: 85.3%), whereas the reference metal-based particle assembly layer-layered substrate presented absorbance/coverage of 0.84 (coverage: 3.9%).

[Producing Organic EL Device and Assessing Emission Intensity]

<Example 1>

Silver particles were grown under the same conditions as Production Example 1 to provide on a 0.5 mm thick soda glass substrate the metal-based particle assembly layer described in Production Example 1. Thereafter immediately a spin-on glass (SOG) solution was applied with spin-coating on the metal-based particle assembly layer to have an insulating layer having an average thickness of 80 nm layered thereon. For the SOG solution was used "OCD T-7 5500T", an organic SOG material produced by TOKYO OHKA KOGYO CO., LTD., which was then diluted with ethanol.

Then ion sputtering was employed to layer an anode electrode that is an IZO layer (thickness: 22 nm) on the insulating layer and thereafter a hole injection layer forming solution was applied on the anode electrode by spin coating to layer a hole injection layer having an average thickness of 20 nm. For the hole injection layer forming solution was used a product of PLEXTRONICS Inc. having a product name "Plexcore AQ 1200" which was then diluted with ethanol to have a prescribed concentration. The insulating layer, the anode electrode, and the hole injection layer have a total average thickness of 122 nm (i.e., an average distance from a surface of the metal-based particle assembly film to the light emitting layer is 122 nm).

Subsequently, a polymeric luminophor soluble in an organic solvent was dissolved in the organic solvent at a prescribed concentration, and this solution was applied on the hole injection layer by spin coating to provide a 100 nm thick light emitting layer. Then, vacuum deposition was employed to deposit an electron injection layer that is a NaF layer (of 2 nm thick), a cathode electrode that is a Mg layer (of 2 nm thick) and an Ag layer (of 10 nm thick) in that order on the light emitting layer. The obtained device had a front surface sealed with a sealant ("XNR5516ZLV", a UV curable resin produced by Nagase Chemtex Corp.) to obtain an organic EL device.

<Comparative Example 1>

An organic EL device was produced similarly as done in Example 1 except that the metal-based particle assembly layer was not provided.

A source meter (a source meter type 2602A produced by Keithley Instruments Inc.) was used to apply a voltage of 15 V to the organic EL device of Example 1 constantly to cause the device to emit light on the condition of a current value passed between the electrodes of 2.3 mA. The emission spectrum was measured with "CS-2000", a spectrometric device produced by Konica Minolta Co., Ltd., and the obtained emission spectrum was integrated for a visible light wavelength range to obtain emission intensity. The emission intensity of the organic EL device of Comparative Example 1 was also obtained, similarly as done for the organic EL device of Example 1 (the same voltage of 15 V as the organic EL device of Example 1 was applied), except that a current value passed between the electrodes was 2.7 mA. It has been confirmed that the resulting organic EL device of Example 1 exhibits an emission intensity approximately 3.8 times that of the organic EL device of Comparative Example 1.

<Example 2>

Silver particles were grown under the same conditions as Example 1 to provide on a 0.5 mm thick soda glass substrate the metal-based particle assembly film described in Example 1. Thereafter immediately a spin-on glass (SOG) solution was applied with spin-coating on the metal-based particle assembly film to have an insulating layer having an average thickness of 30 nm layered thereon. For the SOG solution was used "OCD T-7 5500T", an organic SOG material produced by TOKYO OHKA KOGYO CO., LTD., which was then diluted with ethanol.

Then ion sputtering was employed to layer an anode electrode that is an IZO layer (thickness: 22 nm) on the insulating layer and thereafter a hole injection layer forming solution was applied on the anode electrode by spin coating to layer a hole injection layer having an average thickness of 20 nm. For the hole injection layer forming solution was used a product of PLEXTRONICS Inc. having a product name "Plexcore AQ 1200" which was then diluted with ethanol to have a prescribed concentration. The insulating layer, the anode electrode, and the hole injection layer have a total average thickness of 72 nm (i.e., an average distance from a surface of the metal-based particle assembly film to the light emitting layer is 72 nm).

Subsequently, vacuum deposition was employed to deposit on the hole injection layer a light emitting layer that is Alq$_3$ of 80 nm. Then, vacuum deposition was employed to deposit an electron injection layer that is a NaF layer (of 2 nm thick), a cathode electrode that is a Mg layer (of 2 nm thick) and an Ag layer (of 10 nm thick) in that order on the light emitting layer. The obtained device had a front surface sealed with a sealant ("XNR5516ZLV", a UV curable resin produced by Nagase Chemtex Corp.) to obtain an organic EL device.

<Comparative Example 2>

An organic EL device was produced similarly as done in Example 2 except that the metal-based particle assembly film was not provided.

A source meter (a source meter type 2602A produced by Keithley Instruments Inc.) was used to apply a voltage of 11 V to the organic EL device of Example 2 constantly to cause the device to emit light on the condition of a current value passed between the electrodes of 0.7 mA. The emission spectrum was measured with "CS-2000", a spectrometric device produced by Konica Minolta Co., Ltd., and the obtained emission spectrum was integrated for a visible light wavelength range to obtain emission intensity. The emission intensity of the organic EL device of Comparative Example 2 was also obtained, similarly as done for the organic EL device of Example 2 (the same voltage of 11 V as the organic EL device of Example 2 was applied), except that a current value passed between the electrodes was adjusted to 1.1 mA. It has been confirmed that the resulting organic EL device of Example 2 exhibits an emission intensity approximately 2.6 times that of the organic EL device of Comparative Example 2.

[Producing Photoexcited Light Emitting Device and Assessing Emission Enhancement]

<Reference Example 1-1>

Silver particles were grown under approximately the same conditions as Production Example 1 to provide on a 0.5 mm thick soda glass substrate a metal-based particle assembly layer similar to that of Production Example 1. The metal-based particle assembly layer had metal-based particles having the same shape and average interparticle distance as Production Example 1 except that the metal-based particles had an average height of 66.1 nm.

Then a solution for a coumarin-based light emitting layer was applied with spin-coating on the metal-based particle assembly layer at 3000 rpm to provide a significantly thin coumarin-based light emitting layer (on the scale of monomolecular film) to thus obtain a light emitting device. The solution for the coumarin-based light emitting layer was prepared as follows. Initially, a coumarin dye (Coumarin 503 from Exciton) was dissolved in ethanol to obtain a 5 mM coumarin solution. Separately, an organic SOG material ("OCD T-7 5500T" produced by TOKYO OHKA KOGYO CO., LTD.) was diluted with ethanol to be 33% by volume. The organic SOG material diluted to be 33% by volume, the 5 mM coumarin solution, and ethanol were mixed together to have a volumetric ratio of 1:5:5 to obtain the solution for the coumarin-based light emitting layer.

<Reference Example 1-2>

Silver particles were grown under the same conditions as Reference Example 1-1 to provide on a 0.5 mm thick soda glass substrate the metal-based particle assembly layer described in Reference Example 1-1. Thereafter immediately a SOG solution was applied with spin-coating on the metal-based particle assembly layer to have an insulating layer having an average thickness of 10 nm layered thereon. For the SOG solution was used "OCD T-7 5500T", an organic SOG material produced by TOKYO OHKA KOGYO CO., LTD., which was then diluted with ethanol. "Average thickness" means average thickness as provided on a metal-based particle assembly layer having an irregular surface, and it was measured as thickness provided when the SOG solution was directly applied to the soda glass substrate by spin coating (this is also applied to the following reference and comparative reference examples). When the average thickness has a relatively small value, the metal-based particle assembly layer may have the insulating layer formed only in a trough and may not have its outermost surface entirely covered therewith.

Then the same solution for the coumarin-based light emitting layer as used in Reference Example 1-1 was applied with spin-coating at 3000 rpm on the outermost surface of the metal-based particle assembly layer having the insulating layer as described above to provide a significantly thin coumarin-based light emitting layer (on the scale of monomolecular film) to thus obtain a light emitting device.

<Reference Example 1-3>

A light emitting device was produced similarly as done in Reference Example 1-2 except that the insulating layer had an average thickness of 30 nm.

<Reference Example 1-4>

A light emitting device was produced similarly as done in Reference Example 1-2 except that the insulating layer had an average thickness of 80 nm.

<Reference Example 1-5>

A light emitting device was produced similarly as done in Reference Example 1-2 except that the insulating layer had an average thickness of 150 nm.

<Reference Example 1-6>

A light emitting device was produced similarly as done in Reference Example 1-2 except that the insulating layer had an average thickness of 350 nm.

<Comparative Reference Example 1-1>

An aqueous silver nanoparticle dispersion (produced by Mitsubishi Paper Mills, Ltd., silver nanoparticle concentration: 25% by weight) was diluted with pure water to have a silver nanoparticle concentration of 6% by weight. Then to the aqueous silver nanoparticle dispersion 1% by volume of a surfactant was added and sufficiently agitated and thereafter to the obtained aqueous silver nanoparticle dispersion 80% by volume of acetone was added and sufficiently shaken and thus mixed together at ordinary temperature to prepare a silver nanoparticle coating liquid.

Then, the silver nanoparticle coating liquid was applied with spin-coating at 1500 rpm on a 1 mm thick soda glass substrate having a surface wiped with acetone and thereafter the substrate was left as it is in the atmosphere for 1 minute and subsequently annealed in an electric furnace of 550°C for 5 minutes to obtain a metal-based particle assembly layer-layered substrate.

Fig. 13 is an SEM image, enlarged as scaled 10000 times, of the metal-based particle assembly layer in the metal-based particle assembly layer-layered substrate obtained in Comparative Reference Example 1-1, as observed from directly above. Fig. 14 is an AFM image of the metal-based particle assembly layer in the metal-based particle assembly layer-layered substrate obtained in Comparative Reference Example 1-1. Fig. 14 shows an image having a size of 5 $\mu$m $\times$ 5 $\mu$m.

A calculation with reference to the Fig. 13 SEM image indicates that Comparative Reference Example 1-1 provided a metal-based particle assembly layer configured of silver particles having an average particle diameter of 278 nm and an average interparticle distance of 195.5 nm, as based on the definition indicated above. Furthermore, from the Fig. 14 AFM image, an average height of 99.5 nm was obtained. From these values the silver particle's aspect ratio (average particle diameter/average height) was calculated to be 2.79 and it can also be found from the obtained images that the silver particles have an oblate shape. Furthermore, it can be seen from the SEM image that the metal-based particle assembly layer of Comparative Reference Example 1-1 has approximately $2.18 \times 10^{10}$ silver particles (approximately 8.72 particles/$\mu$m$^2$).

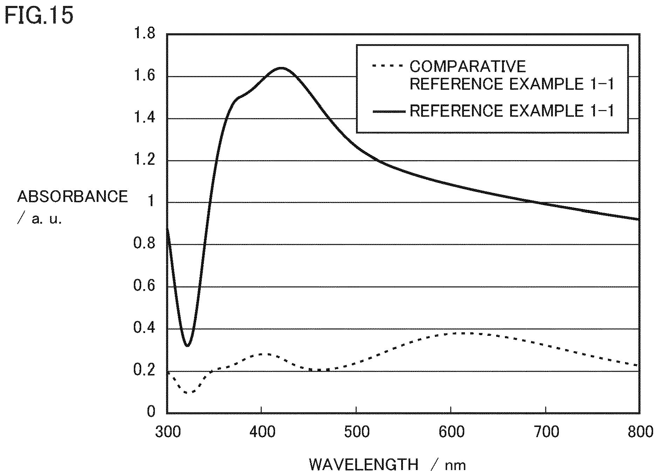

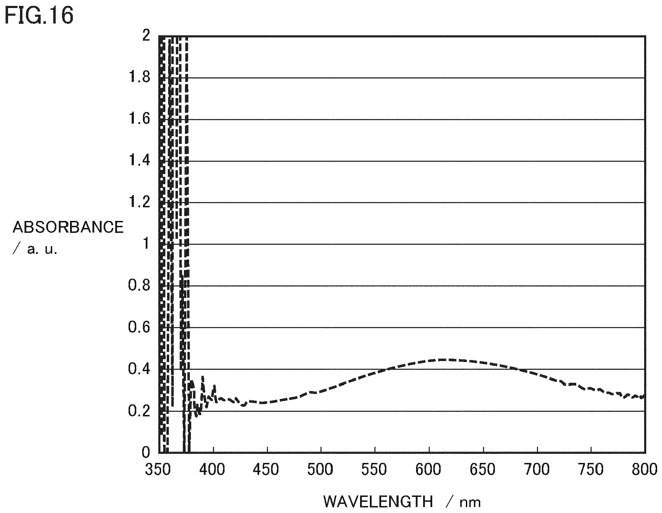

Fig. 15 shows absorption spectra of the metal-based particle assembly layer-layered substrates obtained in Reference Example 1-1 and Comparative Reference Example 1-1, as measured in a method using an integrating sphere spectrophotometer, as set forth above. Furthermore, Fig. 16 shows an absorption spectrum of the metal-based particle assembly layer-layered substrate obtained in Comparative Reference Example 1-1, as measured in a method using an objective lens (100 times) of a microscope. In both methods the metal-based particle assembly layer-layered substrate obtained in Comparative Reference Example 1-1 presented for the visible light region a maximum wavelength of a peak at a longest side in wavelength, and the maximum wavelength was 611 nm. This maximum wavelength is substantially the same as that of the reference metal-based particle assembly film-layered substrate corresponding to the metal-based particle assembly film-layered substrate of Comparative Reference Example 1-1, and the metal-based particle assembly film of Comparative Reference Example 1-1 substantially does not show a blue shift. Furthermore from Fig. 15 it can be found that Reference Example 1-1 presents in an absorption spectrum a peak wavelength (a maximum wavelength of a plasmon peak at a longest side in wavelength) blue-shifted to a larger extent than Comparative Reference Example 1-1, and the plasmon peak at a longest side in wavelength is sharpened and an absorbance at the peak's maximum wavelength is higher.

The Fig. 16 spectrum provides for the visible light region a maximum wavelength of a peak at a longest side in wavelength, and an absorbance at the maximum wavelength is 0.444 and the metal-based particles cover the substrate's surface at a coverage of 53.2%, and therefrom absorbance/coverage of 0.83 is calculated. This absorbance/coverage is smaller than that of the reference metal-based particle assembly layer-layered substrate.

Then, similarly as done in Reference Example 1-1, the metal-based particle assembly layer was provided thereon with a coumarin-based light emitting layer to obtain a light emitting device.

<Comparative Reference Example 1-2>

The same method as Comparative Reference Example 1-1 was employed to provide on a 1 mm thick soda glass substrate the metal-based particle assembly layer described in Comparative Reference Example 1-1. Thereafter immediately a SOG solution was applied with spin-coating on the metal-based particle assembly layer to have an insulating layer having an average thickness of 10 nm layered thereon. For the SOG solution was used "OCD T-7 5500T", an organic SOG material produced by TOKYO OHKA KOGYO CO., LTD., which was then diluted with ethanol.

Then, similarly as done in Reference Example 1-2, the metal-based particle assembly layer having the insulating layer as described above was provided at an outermost surface thereof with a coumarin-based light emitting layer to obtain a light emitting device.

<Comparative Reference Example 1-3>

A light emitting device was produced similarly as done in Comparative Reference Example 1-2 except that the insulating layer had an average thickness of 30 nm.

<Comparative Reference Example 1-4>

A light emitting device was produced similarly as done in Comparative Reference Example 1-2 except that the insulating layer had an average thickness of 80 nm.

<Comparative Reference Example 1-5>

A light emitting device was produced similarly as done in Comparative Reference Example 1-2 except that the insulating layer had an average thickness of 150 nm.

<Comparative Reference Example 1-6>

A light emitting device was produced similarly as done in Comparative Reference Example 1-2 except that the insulating layer had an average thickness of 350 nm.

<Comparative Reference Example 2>

A light emitting device was produced similarly as done in Reference Example 1-1 except that the metal-based particle assembly layer was not provided.

<Reference Example 2-1>

The same method as Reference Example 1-1 was employed to provide on a 0.5 mm thick soda glass substrate the metal-based particle assembly layer described in Reference Example 1-1.
Then a solution for an $Alq_3$ light emitting layer was applied with spin-coating on the metal-based particle assembly layer to form an $Alq_3$ light emitting layer having an average thickness of 30 nm. The solution for the $Alq_3$ light emitting layer was prepared by dissolving $Alq_3$ (Tris-(8-hydroxyquinoline) aluminum from Sigma Aldrich Co. LLC.) in chloroform to have a concentration of 0.5% by weight.

<Reference Example 2-2>

The same method as Reference Example 1-2 was employed to provide a metal-based particle assembly layer having an insulating layer with an average thickness of 10 nm and thereafter the same method as Reference Example 2-1 was employed to form an $Alq_3$ light emitting layer having an average thickness of 30 nm to obtain a light emitting device.

<Reference Example 2-3>

A light emitting device was produced similarly as done in Reference Example 2-2 except that the insulating layer had an average thickness of 30 nm.

<Reference Example 2-4>

A light emitting device was produced similarly as done in Reference Example 2-2 except that the insulating layer had an average thickness of 80 nm.

<Reference Example 2-5>

A light emitting device was produced similarly as done in Reference Example 2-2 except that the insulating layer had an average thickness of 150 nm.

<Comparative Reference Example 3-1 >

The same method as Comparative Reference Example 1-1 was employed to provide on a 1 mm thick soda glass substrate the metal-based particle assembly layer described in Comparative Reference Example 1-1 and thereafter the same method as Reference Example 2-1 was employed to form an $Alq_3$ light emitting layer having an average thickness of 30 nm to obtain a light emitting device.

<Comparative Reference Example 3-2>

The same method as Comparative Reference Example 1-2 was employed to provide a metal-based particle assembly layer having an insulating layer with an average thickness of 10 nm and thereafter the same method as Reference Example 2-1 was employed to form an $Alq_3$ light emitting layer having an average thickness of 30 nm to obtain a light emitting device.

<Comparative Reference Example 3-3>

A light emitting device was produced similarly as done in Comparative Reference Example 3-2 except that the insulating layer had an average thickness of 30 nm.

<Comparative Reference Example 3-4>

A light emitting device was produced similarly as done in Comparative Reference Example 3-2 except that the insulating layer had an average thickness of 80 nm.

<Comparative Reference Example 3-5>

A light emitting device was produced similarly as done in Comparative Reference Example 3-2 except that the insulating layer had an average thickness of 150 nm.

<Comparative Reference Example 4>

A light emitting device was produced similarly as done in Reference Example 2-1 except that the metal-based particle assembly layer was not provided.

<Reference Example 3-1 >

The same method as Reference Example 1-1 was employed to provide on a 0.5 mm thick soda glass substrate the metal-based particle assembly layer described in Reference Example 1-1.
Then a solution for an F8BT light emitting layer was applied with spin-coating on the metal-based particle assembly layer and subsequently annealed with a hot plate at 170°C for 30 minutes to form an F8BT light emitting layer having an average thickness of 30 nm. The solution for the F8BT light emitting layer was prepared by dissolving F8BT (from Luminescence Technology Corp.) in chlorobenzene to have a concentration of 1 % by weight.

<Reference Example 3-2>

The same method as Reference Example 1-2 was employed to provide a metal-based particle assembly layer having an insulating layer with an average thickness of 10 nm and thereafter the same method as Reference Example 3-1 was employed to form an F8BT light emitting layer having an average thickness of 30 nm to obtain a light emitting device.

<Reference Example 3-3>

A light emitting device was produced similarly as done in Reference Example 3-2 except that the insulating layer had an average thickness of 30 nm.

<Comparative Reference Example 5-1>

The same method as Comparative Reference Example 1-1 was employed to provide on a 1 mm thick soda glass substrate the metal-based particle assembly layer described in Comparative Reference Example 1-1 and thereafter the same method as Reference Example 3-1 was employed to form an F8BT light emitting layer having an average thickness of 30 nm to obtain a light emitting device.

<Comparative Reference Example 5-2>

The same method as Comparative Reference Example 1-2 was employed to provide a metal-based particle assembly layer-layered substrate having an insulating layer with an average thickness of 10 nm and thereafter the same method as Reference Example 3-1 was employed to form an F8BT light emitting layer having an average thickness of 30 nm to obtain a light emitting device.

<Comparative Reference Example 5-3>

A light emitting device was produced similarly as done in Comparative Reference Example 5-2 except that the insulating layer had an average thickness of 30 nm.

<Comparative Reference Example 6>

A light emitting device was produced similarly as done in Reference Example 3-1 except that the metal-based particle assembly layer was not provided.

<Comparative Reference Example 7-1>

On a 1 mm thick soda glass substrate a 13 nm thick, thin conductive silver film was deposited through vacuum deposition. The vapor deposition was done in a chamber having an internal pressure set at $3 \times 10^{-3}$ Pa. Then the substrate with the thin conductive silver film deposited thereon was annealed in an electric furnace of 400°C for 10 minutes to obtain a metal-based particle assembly film-layered substrate.

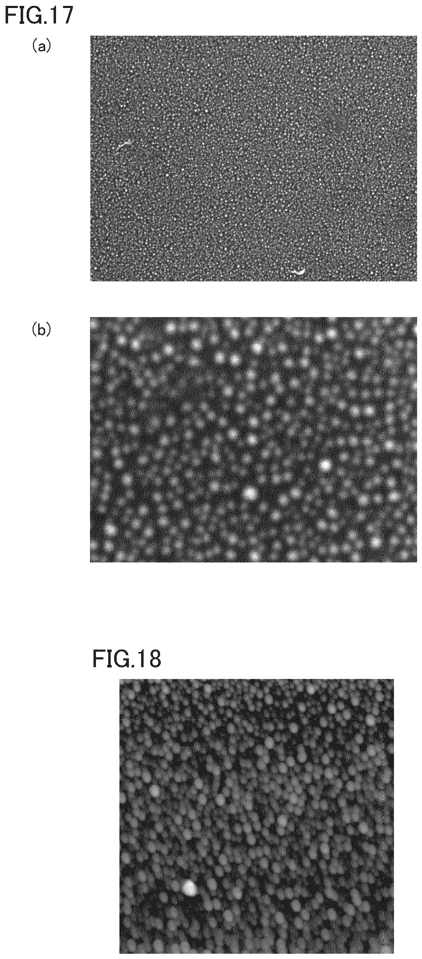

Fig. 17 is SEM images of a metal-based particle assembly film in the obtained metal-based particle assembly film-layered substrate, as observed from directly above. Fig. 17(a) is an image enlarged as scaled 10000 times and Fig. 17(b) is an image enlarged as scaled 50000 times. Fig. 18 is an AFM image of the metal-based particle assembly film in the metal-based particle assembly film-layered substrate obtained in Comparative Reference Example 7-1. Fig. 18 shows an image having a size of 5 $\mu$m $\times$ 5 $\mu$m.

A calculation with reference to the Fig. 17 SEM images indicates that Comparative Reference Example 7-1 provided a metal-based particle assembly configured of silver particles having an average particle diameter of 95 nm and an average interparticle distance of 35.2 nm, as based on the definition indicated above. Furthermore, from the Fig. 18 AFM image, an average height of 29.6 nm was obtained. From these values, the silver particle's aspect ratio (average particle diameter/average height) is calculated to be 3.20.

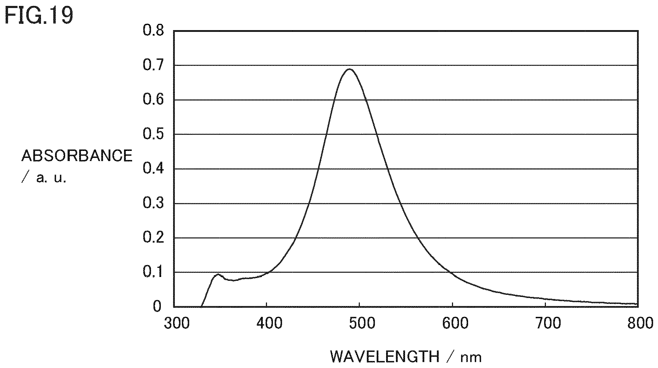

Fig. 19 shows an absorption spectrum of the metal-based particle assembly film-layered substrate obtained in Comparative Reference Example 7-1, as measured as described above. Comparative Reference Example 7-1 presents in an absorption spectrum a peak wavelength (a maximum wavelength of a plasmon peak at a longest side in wavelength) located at a side longer in wavelength than that of the absorption spectrum of Reference Example 1-1 shown in Fig. 15, and also has low absorbance at the peak wavelength.

Then the same method as Reference Example 2-1 was employed to form an Alq$_3$ light emitting layer having an average thickness of 30 nm to obtain a light emitting device.

<Comparative Reference Example 7-2>

The same method as Comparative Reference Example 7-1 was employed to provide on a 1 mm thick soda glass substrate the metal-based particle assembly film described in Comparative Reference Example 7-1. Thereafter immediately a SOG solution was applied with spin-coating on the metal-based particle assembly film to have an insulating layer having an average thickness of 10 nm layered thereon. For the SOG solution was used "OCD T-7 5500T", an organic SOG material produced by TOKYO OHKA KOGYO CO., LTD., which was then diluted with ethanol. Then the same method as Reference Example 2-1 was employed to form an Alq₃ light emitting layer having an average thickness of 30 nm to obtain a light emitting device.

<Comparative Reference Example 7-3>

A light emitting device was produced similarly as done in Comparative Reference Example 7-2 except that the insulating layer had an average thickness of 30 nm.

<Comparative Reference Example 7-4>

A light emitting device was produced similarly as done in Comparative Reference Example 7-2 except that the insulating layer had an average thickness of 80 nm.

<Comparative Reference Example 7-5>

A light emitting device was produced similarly as done in Comparative Reference Example 7-2 except that the insulating layer had an average thickness of 150 nm.

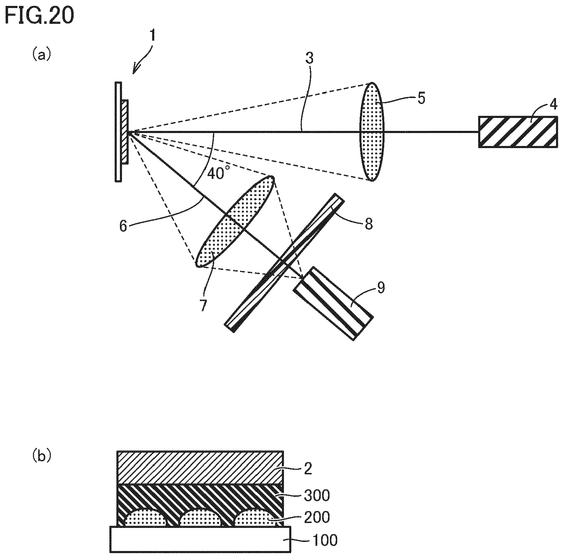

Photoexcited light emitting devices of Reference Examples 1-1, 1-2, 1-3, 1-4, 1-5, 1-6, Reference Examples 2-1, 2-2, 2-3, 2-4, 2-5, Reference Examples 3-1, 3-2, 3-3, Comparative Reference Examples 1-1, 1-2, 1-3, 1-4, 1-5, 1-6, Comparative Reference Example 2, Comparative Reference Examples 3-1, 3-2, 3-3, 3-4, 3-5, Comparative Reference Example 4, Comparative Reference Examples 5-1, 5-2, 5-3, Comparative Example 6, and Comparative Reference Examples 7-1, 7-2, 7-3, 7-4, 7-5 were assessed for emission enhancement in level, as follows. With reference to Fig. 20(a) showing a system employed to measure the photoexcited light emitting devices' emission spectra and Fig. 20(b) showing a schematic cross section view of a photoexcited light emitting device, a light emitting layer 2 side of a photoexcited light emitting device 1 was exposed to excitation light 3 from a direction perpendicular to a surface of light emitting layer 2 to cause photoexcited light emitting device 1 to emit light. For an excitation light source 4 was used a UV-LED (UV-LED375-nano produced by SOUTH WALKER, excitation light wavelength: 375 nm). Radiated was excitation light 3 obtained by condensing the light emitted from excitation light source 4 through a lens 5. An emitted light 6 from the photoexcited light emitting device in a direction of 40 degrees relative to the optical axis of excitation light 3 was condensed by a lens 7 and then transmitted through a wavelength cut-off filter 8 (SCF-50S-44Y produced by SIGMA KOKI Co., LTD) to cut the light of the wavelength of the excitation light and then detected via a spectrophotometer 9 (MCPD-3000 produced by Otsuka Electronics Co., Ltd.). Fig. 20(b) is a schematic cross section view of photoexcited light emitting device 1 including on soda glass substrate 100 a metal-based particle assembly layer 200, an insulating layer 300, and light emitting layer 2 provided in this order, as produced in the reference and comparative reference examples.

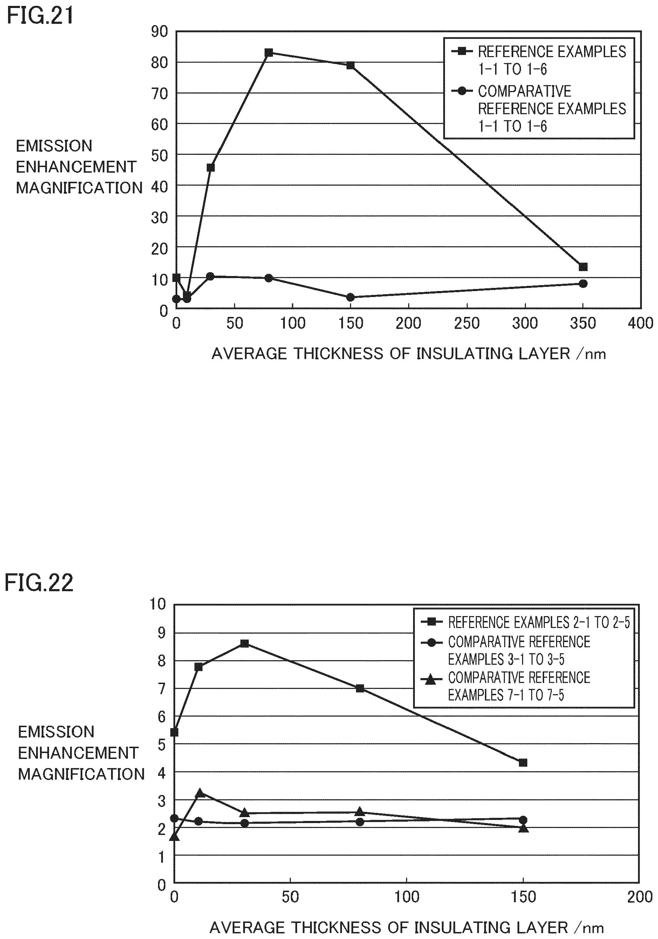

From the spectra of the emissions detected, integrals were obtained for the emission wavelength ranges. The respective integrals obtained from each emission spectrum of the photoexcited light emitting devices of Reference Examples 1-1, 1-2, 1-3, 1-4, 1-5, 1-6 and Comparative Reference Examples 1-1, 1-2, 1-3, 1-4, 1-5, 1-6 were divided by the integral obtained from an emission spectrum of the photoexcited light emitting device of Comparative Reference Example 2 to obtain "emission enhancement magnification", as represented in Fig. 21 along the axis of ordinate.

The respective integrals obtained from each emission spectrum of the photoexcited light emitting devices of Reference Examples 2-1, 2-2, 2-3, 2-4, 2-5, Comparative Reference Examples 3-1, 3-2, 3-3, 3-4, 3-5 and Comparative Reference Examples 7-1, 7-2, 7-3, 7-4, 7-5 were divided by the integral obtained from an emission spectrum of the photoexcited light emitting device of Comparative Reference Example 4 to obtain "emission enhancement magnification", as represented in Fig. 22 along the axis of ordinate.

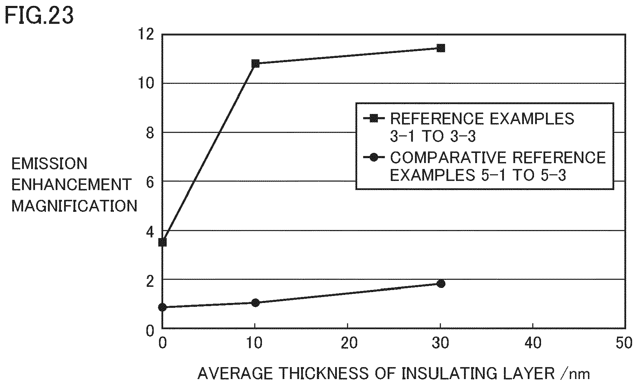

The respective integrals obtained from each emission spectrum of the photoexcited light emitting devices of Reference Examples 3-1, 3-2, 3-3 and Comparative Reference Examples 5-1, 5-2, 5-3 were divided by the integral obtained from an emission spectrum of the photoexcited light emitting device of Comparative Reference Example 6 to obtain "emission enhancement magnification", as represented in Fig. 23 along the axis of ordinate.

REFERENCE SIGNS LIST

1: photoexcited light emitting device; 2: light emitting layer; 3: excitation light; 4: excitation light source; 5, 7: lens; 6: emitted light from photoexcited light emitting device; 8: wavelength cut-off filter; 9: spectrophotometer; 10: substrate; 20: metal-based particle; 30: insulating layer; 40: first electrode layer; 50: light emitting layer; 60: second electrode layer; 100: soda glass substrate; 200: metal-based particle assembly layer; 201: silver film; 300: insulating layer; 400: resist; 401: circular opening; 500: metal-based particle assembly film-layered substrate; 501: substrate; 502: metal-based particle assembly film; 600: objective lens; 700: spectrophotometer.

**Claims**

1.   An organic electroluminescence device comprising:

a first electrode layer (40) and a second electrode layer (60);
a light-emitting layer (50) containing an organic luminescent material and disposed between said first electrode layer and said second electrode layer; and

a metal-based particle assembly layer under the first electrode layer (40), which first electrode layer (40) is provided under the light-emitting layer (50),

wherein the metal-based particle assembly layer is a layer consisting of a particle assembly including 30 or more metal-based particles (20) separated from each other and disposed in two dimensions, said metal-based particles (20) having an average particle diameter in a range of from 200 to 1600 nm, an average height, and an aspect ratio, as defined by a ratio of said average particle diameter to said average height, in a range of from 1 to 8,

**characterised in that**:

the average height is in a range of from 55 to 500 nm,

an average distance between adjacent metal-based particles is in a range of from 1 to 150 nm, and

the absorption plasmon peak at the highest wavelength of the absorption spectrum of visible light of the metal-based particle assembly layer shifts towards lower wavelengths, this wavelength shift being within the range 30-500 nm as compared with the absorption peak at the highest wavelength of the absorption spectrum of visible light of a reference metal-based particle assembly (X) in which metal-based particles have a reference particle diameter equal to said average particle diameter, a reference height equal to said average height, a reference aspect ratio equal to said aspect ratio, made of a same reference material as the material of the metal-based particle assembly and wherein the particles are disposed such that each distance between adjacent metal-based particles of the reference metal-based particle assembly is in a range of from 1 to 2 μm.

2. The organic electroluminescence device according to claim 1, wherein said metal-based particles (20) that compose the metal-based particle assembly layer are oblate particles with said aspect ratio of more than one.

3. The organic electroluminescence device according to claim 1 or 2, wherein said metal-based particles (20) that compose the metal-based particle assembly layer are made of silver.

4. The organic electroluminescence device according to any one of claims 1 to 3, wherein said metal-based particles (20) that compose the metal-based particle assembly layer are non-conductive between adjacent metal-based particles (20).

5. The organic electroluminescence device according to any one of claims 1 to 4, wherein the absorption plasmon peak at the highest wavelength of the absorption spectrum of visible light of the metal-based particle assembly layer is in a range of from 350 to 550 nm.

6. The organic electroluminescence device according to any one of claims 1 to 5, wherein an absorbance at the absorption plasmon peak at the highest wavelength of the absorption spectrum of visible light of the metal-based particle assembly layer is at least one.

7. The organic electroluminescence device according to any one of claims 1 to 6, wherein said metal-based particle assembly layer is disposed closer to a light extraction face than said light-emitting layer (50).

8. The organic electroluminescence device according to any one of claims 1 to 7, comprising a substrate (10), said metal-based particle assembly layer, said first electrode layer (40), said light-emitting layer (50), and said second electrode layer (60) in that order.

9. The organic electroluminescence device according to claim 8, wherein said metal-based particle assembly layer is layered directly on said substrate (10).

10. The organic electroluminescence device according to any one of claims 1 to 9, further comprising an insulating layer (30) covering a surface of each metal-based particle (20) that composes said metal-based particle assembly layer.

11. The organic electroluminescence device according to claim 8 or 9, wherein said substrate (10) is a transparent substrate and the organic electroluminescence device has a light extraction face at a side of said substrate (10) opposite to a side facing said metal-based particle assembly layer.

12. The organic electroluminescence device according to any one of claims 1 to 11, wherein said light-emitting layer (50) has the thickness of at least 10 nm.

13. The organic electroluminescence device according to any one of claims 1 to 12, wherein a distance between a light-emitting layer side surface of said metal-based particle assembly layer and said light-emitting layer (50) is at least 10 nm.

14. The organic electroluminescence device according to any one of claims 1 to 13, wherein a distance between a light-emitting layer side surface of said metal-based particle assembly layer and said light-emitting layer (50) is at least 20 nm, and said organic luminescent material contained in said light-emitting layer (50) has a photoluminescence quantum efficiency of 1.5 times or larger than that of a reference organic electroluminescence device that does not have said metal-based particle assembly layer.

15. A method of enhancing emission of an organic electroluminescence device, the method comprising disposing in said organic electroluminescence device a metal-based particle assembly layer (20) under a first electrode layer of the organic electroluminescence device, which first electrode layer (40) is provided under a light-emitting layer (50), and the light emitting layer (50) under a second electrode layer (60), all three forming the organic electroluminescent device,

wherein the metal-based particle assembly layer is a layer consisting of a particle assembly including 30 or more metal-based particles separated from each other and disposed in two dimensions, said metal-based particles having an average particle diameter in a range of from 200 to 1600 nm, an average height in a range of from 55 to 500 nm, an aspect ratio, as defined by a ratio of said average particle diameter to said average height, in a range of from 1 to 8, and an average distance between adjacent metal-based particles is in a range of from 1 to 150 nm, wherein

the absorption plasmon peak at the highest wavelength of the absorption spectrum of visible light of the metal-based particle assembly layer shifts towards lower wavelengths, this wavelength shift being within the range 30-500 nm as compared with the absorption peak at the highest wavelength of the absorption spectrum of visible light of a reference metal-based particle assembly (X) in which metal-based particles have a reference particle diameter equal to said average particle diameter, a reference height equal to said average height, made of a same reference material as the material of the metal-based particle assembly layer, and wherein the particles are disposed such that each distance between adjacent metal-based particles is in a range of from 1 to 2 $\mu$m.

**Patentansprüche**

1. Organische Elektrolumineszenz-Vorrichtung, die Folgendes umfasst:

eine erste Elektrodenschicht (40) und eine zweite Elektrodenschicht (60);
eine lichtemittierende Schicht (50), die ein organisches Lumineszenzmaterial enthält und zwischen der ersten Elektrodenschicht und der zweiten Elektrodenschicht angeordnet ist; und
eine metallbasierte Partikelanordnungsschicht unter der ersten Elektrodenschicht (40), wobei die erste Elektrodenschicht (40) unter der lichtemittierenden Schicht (50) vorgesehen ist, eine Z-Schicht, wobei die metallbasierte Partikelanordnungsschicht eine Schicht ist, die aus einer Partikelanordnung besteht, die 30 oder mehr metallbasierte Partikel (20) enthält, die voneinander getrennt und in zwei Dimensionen angeordnet sind, wobei die metallbasierten Partikel (20) einen durchschnittlichen Partikeldurchmesser in einem Bereich von 200 bis 1600 nm, eine durchschnittliche Höhe und ein durch ein Verhältnis des durchschnittlichen Partikeldurchmessers zur durchschnittlichen Höhe definiertes Seitenverhältnis in einem Bereich von 1 bis 8 aufweisen,
**dadurch gekennzeichnet, dass**:

die durchschnittliche Höhe in einem Bereich von 55 bis 500 nm liegt,
ein durchschnittlicher Abstand zwischen benachbarten metallbasierten Partikeln in einem Bereich von 1 bis 150 nm liegt, und der Absorptionsplasmonenpeak bei der höchsten Wellenlänge des Absorptionsspektrums des sichtbaren Lichts der Anordnung der metallbasierten Partikel sich zu niedrigeren Wellenlängen hin verschiebt, wobei diese Wellenlängenverschiebung im Vergleich zum Absorptionspeak bei der höchsten Wellenlänge des Absorptionsspektrums von sichtbarem Licht einer metallbasierten Referenzanordnung (X) im Bereich von 30 bis 500 nm liegt, in der metallbasierte Partikel Folgendes aufweisen: einen Referenzpartikeldurchmesser, der gleich dem durchschnittlichen Partikeldurchmesser ist, eine Referenzhöhe, die gleich der durchschnittlichen Höhe ist, ein Referenzseitenverhältnis, das gleich dem Seitenverhältnis ist, und aus demselben Referenzmaterial wie das Material der metallbasierten Partikelanordnung bestehen und wobei die Partikel so angeordnet sind, dass jeder Abstand zwischen benachbarten metallbasierten Partikeln der metallbasierten Referenzpartikelanordnung in einem Bereich von 1 bis 2 $\mu$m liegt.

2. Organische Elektrolumineszenz-Vorrichtung nach Anspruch 1, wobei die metallbasierten Partikel (20), die die Schicht der Anordnung der metallbasierten Partikel bilden, abgeflachte Partikel mit einem Seitenverhältnis von mehr als eins sind.

3. Organische Elektrolumineszenz-Vorrichtung nach Anspruch 1 oder 2, wobei die metallbasierten Partikel (20), die die Anordnung der metallbasierten Partikel bilden, aus Silber bestehen.

4. Organische Elektrolumineszenz-Vorrichtung nach einem der Ansprüche 1 bis 3, wobei die metallbasierten Partikel (20), die die Anordnung der metallbasierten Partikel bilden, zwischen benachbarten metallbasierten Partikeln (20) nicht leitend sind.

5. Organische Elektrolumineszenz-Vorrichtung nach einem der Ansprüche 1 bis 4, wobei der Absorptionsplasmonenpeak bei der höchsten Wellenlänge des Absorptionsspektrums des sichtbaren Lichts der metallbasierten Partikelanordnungsschicht in einem Bereich von 350 bis 550 nm liegt.

6. Organische elektrolumineszente Vorrichtung nach einem der Ansprüche 1 bis 5, wobei die Absorption am Absorptionsplasmonenpeak bei der höchsten Wellenlänge des Absorptionsspektrums des sichtbaren Lichts der metallbasierten Partikelanordnungsschicht mindestens eins beträgt.

7. Organische Elektrolumineszenz-Vorrichtung nach einem der Ansprüche 1 bis 6, wobei die metallbasierten Partikelanordnungsschicht näher an einer Lichtextraktionsfläche angeordnet ist als die lichtemittierende Schicht (50).

8. Organische Elektrolumineszenz-Vorrichtung nach einem der Ansprüche 1 bis 7, die ein Substrat (10), die Anordnung der metallbasierten Partikel, die erste Elektrodenschicht (40), die lichtemittierende Schicht (50) und die zweite Elektrodenschicht (60) in dieser Reihenfolge umfasst.

9. Organische Elektrolumineszenz-Vorrichtung nach Anspruch 8, wobei die metallbasierte Partikelanordnungsschicht direkt auf das Substrat (10) geschichtet ist.

10. Organische Elektrolumineszenz-Vorrichtung nach einem der Ansprüche 1 bis 9, die ferner eine Isolierschicht (30) umfasst, die eine Oberfläche jedes metallbasierten Partikels (20) bedeckt, aus dem die Schicht mit der Anordnung der metallbasierten Partikel besteht.

11. Organische Elektrolumineszenz-Vorrichtung nach Anspruch 8 oder 9, wobei das Substrat (10) ein transparentes Substrat ist und die organische Elektrolumineszenz-Vorrichtung eine Lichtextraktionsfläche auf einer Seite des Substrats (10) aufweist, die einer der metallbasierten Partikelanordnungsschicht zugewandten Seite gegenüberliegt.

12. Organische Elektrolumineszenzvorrichtung nach einem der Ansprüche 1 bis 11, wobei die lichtemittierende Schicht (50) eine Dicke von mindestens 10 nm aufweist.

13. Organische Elektrolumineszenzvorrichtung nach einem der Ansprüche 1 bis 12, wobei ein Abstand zwischen einer Seitenfläche der lichtemittierenden Schicht der metallbasierten Partikelanordnungsschicht und der lichtemittierenden Schicht (50) mindestens 10 nm beträgt.

14. Organische Elektrolumineszenzvorrichtung nach einem der Ansprüche 1 bis 13, wobei ein Abstand zwischen einer Seitenfläche der lichtemittierenden Schicht der metallbasierten Partikelanordnungsschicht und der lichtemittierenden Schicht (50) mindestens 20 nm beträgt, und das in der lichtemittierenden Schicht (50) enthaltene organische lumineszierende Material eine Photolumineszenz-Quanteneffizienz aufweist, die das 1,5-fache oder mehr ist als die einer organischen elektrolumineszierenden Vorrichtung, die nicht die metallbasierte Partikelanordnungsschicht aufweist.

15. Verfahren zur Verbesserung der Emission einer organischen Elektrolumineszenzvorrichtung, wobei das Verfahren das Anordnen einer metallbasierten Partikelanordnungsschicht (20) in der organischen Elektrolumineszenzvorrichtung unter einer ersten Elektrodenschicht der organischen Elektrolumineszenzvorrichtung umfasst, wobei die erste Elektrodenschicht (40) unter einer lichtemittierenden Schicht (50) und die lichtemittierende Schicht (50) unter einer zweiten Elektrodenschicht (60) vorgesehen ist, wobei alle drei die organische elektrolumineszente Vorrichtung bilden,

wobei die metallbasierte Partikelanordnungsschicht eine Schicht ist, die aus einer Partikelanordnung besteht, die 30 oder mehr metallbasierte Partikel enthält, die voneinander getrennt und in zwei Dimensionen angeordnet sind, wobei die metallbasierten Partikel einen durchschnittlichen Partikeldurchmesser in einem Bereich von 200 bis 1600 nm, eine durchschnittliche Höhe in einem Bereich von 55 bis 500 nm, ein durch ein Verhältnis des durchschnittlichen Partikeldurchmessers zur durchschnittlichen Höhe definiertes Seitenverhältnis in einem Bereich von 1 bis 8 aufweisen, ein durchschnittlicher Abstand zwischen benachbarten metallbasierten Partikeln in einem Bereich von 1 bis 150 nm liegt, wobei

der Absorptionsplasmonenpeak bei der höchsten Wellenlänge des Absorptionsspektrums des sichtbaren Lichts der Anordnung der metallbasierten Partikel sich zu niedrigeren Wellenlängen hin verschiebt, wobei diese Wellenlängenverschiebung im Vergleich zum Absorptionspeak bei der höchsten Wellenlänge des Absorptionsspektrums von sichtbarem Licht einer metallbasierten Referenzanordnung (X) im Bereich von 30 bis 500 nm liegt, in der metallbasierte Partikel Folgendes einen Referenzpartikeldurchmesser aufweisen, der gleich dem durchschnittlichen Partikeldurchmesser ist, eine Referenzhöhe aufweisen, die gleich der durchschnittlichen Höhe ist, aus dem gleichen Referenzmaterial wie das Material der metallbasierten Partikelanordnung bestehen, und wobei die Partikel so angeordnet sind, dass jeder Abstand zwischen benachbarten metallbasierten Partikeln in einem Bereich von 1 bis 2 μm liegt.

**Revendications**

1. Dispositif d'électroluminescence organique comprenant :

une première couche d'électrode (40) et une deuxième couche d'électrode (60) ;
une couche électroluminescente (50) contenant un matériau luminescent organique et disposée entre ladite première couche d'électrode et ladite deuxième couche d'électrode ; et
une couche d'assemblage de particules à base de métal sous la première couche d'électrode (40), laquelle première couche d'électrode (40) est prévue sous la couche électroluminescente (50), dans lequel la couche d'assemblage de particules à base de métal est une couche constituée d'un assemblage de particules comprenant 30 particules à base de métal (20) ou plus séparées les unes des autres et disposées en deux dimensions, lesdites particules à base de métal (20) ayant un diamètre moyen de particule dans une plage de 200 à 1600 nm, une hauteur moyenne, et un rapport d'aspect, tel que défini par un rapport dudit diamètre moyen de particule par rapport à ladite hauteur moyenne, dans une plage de 1 à 8, **caractérisé en ce que** :

la hauteur moyenne est dans une plage de 55 à 500 nm,
une distance moyenne entre des particules à base de métal adjacentes est dans une plage de 1 à 150 nm, et
le pic de plasmon d'absorption à la longueur d'onde la plus élevée du spectre d'absorption de la lumière visible de la couche d'assemblage de particules à base de métal se décale vers des longueurs d'onde inférieures, ce décalage de longueur d'onde étant dans la plage de 30 à 500 nm par rapport au pic d'absorption à la longueur d'onde la plus élevée du spectre d'absorption de la lumière visible d'un assemblage de particules à base de métal de référence (X) dans lequel les particules à base de métal ont un diamètre de particule de référence égal audit diamètre moyen de particule, une hauteur de référence égale à ladite hauteur moyenne, un rapport d'aspect de référence égal audit rapport d'aspect, sont constituées d'un même matériau de référence que le matériau d'assemblage de particules à base de métal et dans lequel les particules sont disposées de sorte que chaque distance entre des particules adjacentes à base de métal de l'assemblage de particules à base de métal de référence est dans une plage de 1 à 2 μm.

2. Dispositif d'électroluminescence organique selon la revendication 1, dans lequel lesdites particules à base de métal (20) qui composent la couche d'assemblage de particules à base de métal sont des particules oblates avec ledit rapport d'aspect supérieur à un.

3. Dispositif d'électroluminescence organique selon la revendication 1 ou 2, dans lequel lesdites particules à base de métal (20) qui composent la couche d'assemblage de particules à base de métal sont en argent.

4. Dispositif d'électroluminescence organique selon l'une quelconque des revendications 1 à 3, dans lequel lesdites particules à base de métal (20) qui composent la couche d'assemblage de particules à base de métal sont non conductrices entre les particules à base de métal adjacentes (20).

5. Dispositif d'électroluminescence organique selon l'une quelconque des revendications 1 à 4, dans lequel le pic de plasmon d'absorption à la longueur d'onde la plus élevée du spectre d'absorption de la lumière visible de la couche d'assemblage de particules à base de métal est dans une plage de 350 à 550 nm.

6. Dispositif d'électroluminescence organique selon l'une quelconque des revendications 1 à 5, dans lequel une absorbance au pic de plasmon d'absorption à la longueur d'onde la plus élevée du spectre d'absorption de la lumière visible de la couche d'assemblage de particules à base de métal est d'au moins un.

**7.** Dispositif d'électroluminescence organique selon l'une quelconque des revendications 1 à 6, dans lequel ladite couche d'assemblage de particules à base de métal est disposée plus près d'une face d'extraction de lumière que ladite couche électroluminescente (50).

**8.** Dispositif d'électroluminescence organique selon l'une quelconque des revendications 1 à 7, comprenant un substrat (10), ladite couche d'assemblage de particules à base de métal, ladite première couche d'électrode (40), ladite couche électroluminescente (50), et ladite deuxième couche d'électrode (60) dans cet ordre.

**9.** Dispositif d'électroluminescence organique selon la revendication 8, dans lequel ladite couche d'assemblage de particules à base de métal est déposée directement sur ledit substrat (10).

**10.** Dispositif d'électroluminescence organique selon l'une quelconque des revendications 1 à 9, comprenant en outre une couche isolante (30) recouvrant une surface de chaque particule à base de métal (20) qui compose ladite couche d'assemblage de particules à base de métal.

**11.** Dispositif d'électroluminescence organique selon la revendication 8 ou 9, dans lequel ledit substrat (10) est un substrat transparent et le dispositif d'électroluminescence organique a une face d'extraction de lumière sur un côté dudit substrat (10) opposé à un côté faisant face à ladite couche d'assemblage de particules à base de métal.

**12.** Dispositif d'électroluminescence organique selon l'une quelconque des revendications 1 à 11, dans lequel ladite couche électroluminescente (50) a une épaisseur d'au moins 10 nm.

**13.** Dispositif d'électroluminescence organique selon l'une quelconque des revendications 1 à 12, dans lequel une distance entre une surface côté couche électroluminescente de ladite couche d'assemblage de particules à base de métal et ladite couche électroluminescente (50) est d'au moins 10 nm.

**14.** Dispositif d'électroluminescence organique selon l'une quelconque des revendications 1 à 13, dans lequel une distance entre une surface côté couche électroluminescente de ladite couche d'assemblage de particules à base de métal et ladite couche électroluminescente (50) est d'au moins 20 nm, et ledit matériau luminescent organique contenu dans ladite couche électroluminescente (50) a une efficacité quantique de photoluminescence de 1,5 fois ou supérieure à celle d'un dispositif d'électroluminescence organique de référence qui n'a pas ladite couche d'assemblage de particules à base de métal.

**15.** Procédé d'amélioration de l'émission d'un dispositif d'électroluminescence organique, le procédé comprenant la disposition dans ledit dispositif d'électroluminescence organique d'une couche d'assemblage de particules à base de métal (20) sous une première couche d'électrode du dispositif d'électroluminescence organique, laquelle première couche d'électrode (40) est prévue sous une couche électroluminescente (50), et la couche électroluminescente (50) sous une deuxième couche d'électrode (60), toutes trois formant le dispositif électroluminescent organique,

dans lequel la couche d'assemblage de particules à base de métal est une couche constituée d'un assemblage de particules comprenant 30 particules à base de métal ou plus séparées les unes des autres et disposées en deux dimensions, lesdites particules à base de métal ayant un diamètre moyen de particule dans une plage de 200 à 1600 nm, une hauteur moyenne dans une plage de 55 à 500 nm, un rapport d'aspect, tel que défini par un rapport dudit diamètre moyen de particule par rapport à ladite hauteur moyenne, dans une plage de 1 à 8, et une distance moyenne entre des particules à base de métal adjacentes est dans une plage de 1 à 150 nm,
dans lequel le pic d'absorption de plasmon à la longueur d'onde la plus élevée du spectre d'absorption de la lumière visible de la couche d'assemblage de particules à base de métal se décale vers des longueurs d'onde inférieures, ce décalage de longueur d'onde étant dans la plage de 30 à 500 nm par rapport au pic d'absorption à la longueur d'onde la plus élevée du spectre d'absorption de la lumière visible d'un assemblage de particules à base de métal de référence (X) dans lequel les particules à base de métal ont un diamètre de particule de référence égal audit diamètre moyen de particule, une hauteur de référence égale à ladite hauteur moyenne, sont constituées d'un même matériau de référence que le matériau de la couche d'assemblage de particules à base de métal, et dans lequel les particules sont disposées de sorte que chaque distance entre des particules à base de métal adjacentes est dans une plage de 1 à 2 $\mu$m.

FIG.1

FIG.2

(a)

(b)

ENLARGED

## FIG.3

## FIG.4

(a)

(b)

FIG.5

FIG.6

FIG.7

WAVELENGTH / nm

FIG.8

(a)

400

100

(b)

401                    401

400

100

(c)

201

400

100

(d)

201

100

FIG.9

(a)

(b)

FIG.10

FIG.11

FIG.12

FIG.13

FIG.14

FIG.15

FIG.16

## FIG.17

(a)

(b)

## FIG.18

FIG.19

ABSORBANCE / a. u.

WAVELENGTH / nm

FIG.20

(a)

(b)

FIG.21

FIG.22

FIG.23

AVERAGE THICKNESS OF INSULATING LAYER /nm

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2007139540 A
- WO 2005033335 A
- EP 2203030 A1
- US 2007114523 A1
- WO 2008082569 A1
- US 2011204773 A1
- GB 2465122 A
- JP 8271431 A

### Non-patent literature cited in the description

- **T. FUKUURA ; M. KAWASAKI.** Long Range Enhancement of Molecular Fluorescence by Closely Packed Submicro-scale Ag Islands. *e-Journal of Surface Science and Nanotechnology,* 2009, vol. 7, 653
- Particle Measurement Technique. Nikkan Kogyo Shimbun, Ltd, 1994, 5
- **K. LANCE KELLY et al.** The Optical Properties of Metal Nanoparticles: The Influence of Size, Shape, and Dielectric Environment. *The Journal of Physical Chemistry B,* 2003, vol. 107, 668